Europäisches Patentamt

**European Patent Office**

Office européen des brevets

(19)

(11) Veröffentlichungsnummer : **0 432 241 B1**

(12) **EUROPÄISCHE PATENTSCHRIFT**

(45) Veröffentlichungstag der Patentschrift :
06.09.95 Patentblatt 95/36

(21) Anmeldenummer : **90909336.1**

(22) Anmeldetag : **23.06.90**

(86) Internationale Anmeldenummer :
**PCT/DE90/00479**

(87) Internationale Veröffentlichungsnummer :
**WO 91/00528 10.01.91 Gazette 91/02**

(51) Int. Cl.⁶ : **G01R 33/34**

(54) **PROBENKOPF FÜR DIE KERNRESONANZ-GANZKÖRPER-TOMOGRAPHIE ODER DIE ORTSABHÄNGIGE IN-VIVO KERNRESONANZ-SPEKTROSKOPIE.**

(30) Priorität : **05.07.89 DE 3922034**

(43) Veröffentlichungstag der Anmeldung :
**19.06.91 Patentblatt 91/25**

(45) Bekanntmachung des Hinweises auf die
Patenterteilung :
**06.09.95 Patentblatt 95/36**

(84) Benannte Vertragsstaaten :
**CH DE FR GB IT LI NL**

(56) Entgegenhaltungen :
**EP-A- 0 160 942
DE-A- 3 237 250
GB-A- 2 134 323
GB-A- 2 159 958
US-A- 4 751 464
JOURNAL OF PHYSICS E/SCIENTIFIC IN-
STRUMENTS, Band 20, Nr. 12, Dezember 1987,
IOP Publishing Ltd., (Bristol, GB) ; A. SOTGIU
et al. : "Electric fields and losses in lumped
element resonators for ESR spectroscopy",
Seiten 1487-1490.**

(73) Patentinhaber : **Max-Planck-Gesellschaft zur
Förderung der Wissenschaften e.V. Berlin
Hofgartenstrasse 2
D-80539 München (DE)**

(72) Erfinder : **BRUNNER, Hermann
Siegfriedstrasse 9
D-6905 Schriesheim (DE)**
Erfinder : **HAUSSER, Karl, Hermann
Im Bäckerfeld 6
D-6900 Heidelberg (DE)**
Erfinder : **VEITH, Werner
Bergstrasse 152
D-6900 Heidelberg (DE)**

(74) Vertreter : **Witte, Alexander, Dr.-Ing. et al
Witte, Weller, Gahlert & Otten
Patentanwälte
Rotebühlstrasse 121
D-70178 Stuttgart (DE)**

## Beschreibung

Die Erfindung betrifft einen Probenkopf für die Kernresonanz-Ganzkörper-Tomographie oder die ortsabhängige in-vivo Kernresonanz-Spektroskopie, mit einer Hochfrequenz-Spule, die jeweils eine Anzahl von in Richtung des Hochfrequenz-Stromes abwechselnd hintereinander angeordneten induktiven Abschnitten in Gestalt von metallischen Bändern, sowie kapazitiven Abschnitten umfaßt, derart, daß die Feldlinien des von der Hochfrequenz-Spule erzeugten Hochfrequenz-Magnetfeldes parallel zu einer von der Hochfrequenz-Spule umschlossenen Achse verlaufen. Ein Probenkopf der vorstehend genannten Art ist aus der DE-OS 35 12 682 bekannt.

In der Kernresonanz-Ganzkörper-Tomographie wird ein menschlicher Körper als Ganzes oder ein Teil des menschlichen Körpers einem konstanten Magnetfeld hoher Feldstärke und großer Homogenität sowie einem Hochfrequenz-Magnetfeld ausgesetzt, dessen Feldlinien senkrecht zu den Feldlinien des Konstant-Magnetfeldes gerichtet sind. Durch geeignete Verfahren können nun Schnittbilder des menschlichen Körpers oder eines Teils davon erzeugt werden, indem Kernresonanzen in bestimmten punktförmigen Raumbereichen der Schnittebene angeregt und gemessen werden.

Einzelheiten der Kernresonanz-Ganzkörper-Tomographie, und zwar sowohl hinsichtlich der eingesetzten Meßmethoden wie auch hinsichtlich der hierzu erforderlichen Apparaturen sind aus dem DE-Buch von Hausser, K.H. und H.R. Kalbitzer "NMR für Mediziner und Biologen", Springer-Verlag, 1989, oder dem US-Buch von Wehrli, Felix W., Derek Shaw und J. Bruce Kneeland, BIOMEDICAL MAGNETIC RESONANCE IMAGING, VCH Publishers, Inc., 1988, zu entnehmen.

Bei dem aus der eingangs genannten DE-OS 35 12 682 bekannten Probenkopf wird eine "offene" Hochfrequenz-Spulenanordnung verwendet, die aus zwei klappsymmetrisch zueinander angeordneten Sattelspulen besteht. Die Sattelspulen sind ihrerseits aus langgestreckten Abschnitten von Metallstreifen zusammengesetzt, wobei die einzelnen Abschnitte an ihren Enden mittels Isolierelementen miteinander in Verbindung stehen. Jede der beiden Sattelspulen besteht dabei aus zwei vertikalen, parallel zueinander angeordneten Metallstreifen, die an ihren oberen Enden mit einem kreisbogenförmig verlaufenden Metallstreifen miteinander in Verbindung stehen. Die unteren Enden jeweils eines vertikalen Metallstreifens jeder Sattelspule sind mittels eines querverlaufenden Metallstreifens miteinander zu einer Elektrode verbunden, während die unteren Enden der beiden anderen vertikalen Metallstreifen mit einem Ende zweier weiterer kreisbogenförmiger Metallstreifen verbunden sind, deren gegenüberliegende Enden ebenfalls mit einem weiteren, querverlaufenden Metallstreifen zu einer zweiten Elektrode verbunden sind, die in der Nähe der erstgenannten Elektrode und parallel zu dieser angeordnet ist.

Wird über die beiden Elektroden Strom durch die so erzeugte Doppel-Sattelspule geleitet, so ergibt sich eine Richtung des Hochfrequenz-Magnetfeldes senkrecht zu den von den beiden Sattelspulen definierten und parallel zueinander angeordneten Spulenflächen. Die Spule besteht zwar aus acht Abschnitten, ist aber im Sinne der vorliegenden Anmeldung eine Hintereinanderschaltung von zwei Vierspalt-Spulen ohne Metallrückführung.

Bei der bekannten Spulenanordnung wirken die Isolierkörper zwischen den Enden der Metallstreifen als kapazitive Elemente, während die Metallstreifen selbst als induktive Elemente wirken. Als Isolierkörper können dabei Festkörper oder Gase oder Kondensatoren verwendet werden.

Mit der bekannten Anordnung soll ein einfacher Aufbau erzielbar sein, weil die elektrisch voneinander isolierten Metallstreifen leicht aneinandergefügt werden können, ohne daß es erforderlich ist, eine Doppel-Sattelspule durch Verbiegen eines als Leiter dienenden Kupferröhrchens herzustellen.

Aus der US-PS 4 733 190 ist eine weitere Hochfrequenz-Spulenanordnung für bildgebende Kernresonanz-Verfahren bekannt.

Bei dieser bekannten Anordnung wird ein Paar von Hochfrequenz-Spulen verwendet, dessen Einzelspulen parallel zueinander und im axialen Abstand angeordnet sind. Jede Einzelspule des Spulenpaars besteht aus drei umlaufenden Metallbändern, die an ihren Enden nach innen umgebogen sind und einen gewissen Abstand zum umgebogenen Ende des jeweils benachbarten Bandes einhalten. Auf diese Weise werden ebenfalls induktive Abschnitte durch die metallischen Bänder und kapazitive Abschnitte durch die von den umgebogenen Bandenden gebildeten Luftspalte erzeugt.

Bei der bekannten Spulenanordnung werden die Einzelspulen so von Strom durchflossen, daß die Spulenanordnung als Spaltspule wirkt. Dies bedeutet, daß die Feldlinien des Hochfrequenz-Magnetfeldes die Einzelspulen zwar axial durchsetzen, jedoch in entgegengesetzter Richtung in den Zwischenraum zwischen den beiden Einzelspulen eintreten. Insgesamt ist die resultierende Richtung des Hochfrequenz-Magnetfeldes im Spalt zwischen den beiden Einzelspulen damit senkrecht zur Achse der Spulenanordnung gerichtet. Die Spaltspule kann daher mit ihrer Symmetrieachse in Richtung des Konstant-Magnetfeldes eingesetzt werden, weil der zu untersuchende Körper, wenn er in den Spalt zwischen den beiden Einzelspulen gebracht wird, dort von

2

Feldlinien des Hochfrequenz-Magnetfeldes durchsetzt wird, die quer zur Symmetrieachse der Spulenanordnung und damit senkrecht zu den Feldlinien des Konstant-Magnetfeldes stehen.

Aus der EP-OS 0 160 942 ist eine weitere Spulenanordnung für bildgebende Kernresonanz-Verfahren bekannt.

Bei dieser bekannten Spulenanordnung befinden sich zwei metallische Bänder auf der Außen- und Innenoberfläche eines Hohlzylinders mit elliptischem Querschnitt. Auf den Breitseiten des so gebildeten Körpers ist zu beiden Seiten ein großes Fenster angeordnet, das einen freien Zugang zum Innenraum des Körpers ermöglicht.

Bei dieser bekannten Anordnung fließt der Hochfrequenz-Strom in Richtung der Längsachse des Körpers, mit der Folge, daß die Feldlinien des Hochfrequenz-Magnetfeldes den Innenraum dieses Körpers in einer Richtung senkrecht zur Längsachse durchsetzen.

Entsprechendes gilt für eine weitere Spulenanordnung, wie sie aus der US-PS 4 751 464 bekannt ist. Bei dieser bekannten Spulenanordnung ist eine Vielzahl von 16 Leitern auf der gedachten Wand eines Hohlzylinders, innerhalb eines zylindrischen Abschirmgehäuses, angeordnet. Auch hier werden die Leiter in axialer Richtung von Hochfrequenz-Strom durchflossen, der über kapazitive Koppelelemente von den Stirnseiten des Abschirmgehäuses in die Leiter eingekoppelt wird.

Auch auf diese Weise stellt sich ein Verlauf der Feldlinien des Hochfrequenz-Magnetfeldes ein, bei dem die genannten Feldlinien senkrecht zur Längsachse der Spulenanordnung verlaufen.

Bei einer weiteren Spulenanordnung, wie sie in der EP-OS 0 268 083 beschrieben ist, wird ein Oberflächenresonator durch eine einzige Windung eines bandförmigen elektrischen Leiters gebildet. Der Oberflächenresonator hat dabei eine trichterförmige Gestalt, so daß er mit einer größeren oder einer kleineren Öffnung auf den zu messenden Körper als Oberflächenspule aufgesetzt werden kann.

Schließlich ist aus der DE-OS 32 37 250 noch ein Resonator für Elektronenspinresonanz-Messungen bekannt. Dieser Resonator, der im Mikrowellenbereich eingesetzt wird, umfaßt zwei hohlzylindersegmentförmige Bauelemente, die symmetrisch zur Längsachse eines zylindrischen Abschirmgehäuses in diesem angeordnet sind. Der Abstand der hohlzylindersegmentförmigen Elemente von der Wand des Abschirmgehäuses ist dabei etwa gleich ihrem Radius. In diesem Zusammenhang wird auch eine Anordnung mit vier hohlzylindersegmentförmigen Elementen beschrieben, die jeweils einen Sektor von etwa 90° eines Hohlzylinders ausmachen. Dabei ist jedoch vorgesehen, jeweils um 180° gegenüberliegende Elemente aus einer Hochfrequenzquelle, die gesamte Anordnung also mit zwei Hochfrequenzquellen zu speisen, um Mehrfachresonanz-Messungen auszuführen.

Da, wie erwähnt, die zuletzt genannte Anordnung für Elektronenspinresonanz-Messungen im Mikrowellenbereich vorgesehen ist, bewegen sich die Abmessungen dieser Anordnung im Bereich weniger Zentimeter oder darunter.

Den vorstehend erläuterten Anordnungen, soweit sie überhaupt für Kernresonanz-Ganzkörper-Tomographie-Messungen einsetzbar sind, ist vor allem ein wesentlicher Nachteil zueigen:

Die moderne Kernresonanz-Ganzkörper-Tomographie arbeitet mit statischen Magnetfeldern von ca. 0,15 - 1,5 Tesla, entsprechend einer Protonen-Resonanzfrequenz von ca. 6 - 60 MHz. Noch wesentlich höhere Magnetfelder im Bereich von 3 - 4 Tesla, entsprechend 130 - 170 MHz Protonen-Resonanzfrequenz, werden für die ortsabhängige in-vivo Spektroskopie verwendet, weil die Auflösung der Spektren infolge der chemischen Verschiebung linear mit der Feldstärke zunimmt. Dabei treten in der Praxis u.a. die folgenden Probleme auf:

Zum einen wird es bei solchen Feldstärken immer schwieriger, das erforderliche Konstant-Magnetfeld in der gewünschten Stärke, aber auch mit der gewünschten Homogenität in dem erforderlichen großen Probenraum mit Abmessungen von mehreren Dezimetern zu erzeugen. Hochfeld-Magnete oberhalb von 0,3 Tesla, d.h. weit oberhalb der Sättigungsgrenze von Eisen, sind jedoch nur in Supraleitungs-Technik aufzubauen. Es liegt daher auf der Hand, daß eine Erhöhung der Feldstärke mit einer weit überproportionalen Erhöhung der Kosten verbunden ist, wenn von Meßräumen der genannten Größenordnung die Rede ist.

Es ist daher ein allgemeines Bestreben in der Fachwelt, Probenköpfe der eingangs genannten Art möglichst klein aufzubauen, damit der Nutzraum des supraleitenden Magnetsystems nur um so viel größer als der zu messende menschliche Körper ist, wie dies gerade noch notwendig ist.

Ein weiteres, in der Vergangenheit häufig nicht erkanntes oder unterschätztes Problem liegt darin, daß der menschliche Körper bei Tomographie-Messungen nicht nur dem Konstant-Magnetfeld, sondern auch dem Hochfrequenz-Feld ausgesetzt wird.

Während man sich heute in der Fachwelt dahingehend einig ist, daß weder das Konstant-Magnetfeld noch das Hochfrequenz-Magnetfeld zu physiologischen Störungen führt, wenn man einmal von mittelbaren Rückwirkungen auf Hilfsgeräte (z.B. Herzschrittmacher) absieht, so ist doch zu bedenken, daß jedes elektromagnetische Hochfrequenz-Feld auch ein elektrisches Hochfrequenz-Feld beinhaltet, das zwangsläufig mit den dielektrischen Substanzen des menschlichen Körpers wechselwirkt, namentlich über eine Dipol-Wechselwirkung mit den Molekülen des Wassers, aus dem der menschliche Körper bekanntlich zu mehr als der Hälfte besteht.

Besonders kritisch ist dabei, daß die dielektrischen Verluste, d.h. der Energieübergang vom elektrischen Hochfrequenz-Feld in die Substanz des menschlichen Körpers mit dem Quadrat der elektrischen Feldstärke zunehmen. Dies bedeutet, daß bei einer Verdoppelung der elektrischen Feldstärke eine Vervierfachung der dielektrischen Verluste eintritt. Diese dielektrischen Verluste sind jedoch aus zwei Gründen äußerst störend: Erstens wird durch die wegen der Inhomogenität der Meßprobe, hier des menschlichen Körpers, räumlich sehr ungleichmäßigen Verluste das Hochfrequenzfeld verzerrt, was zusätzliche Artefakte verursacht und sich negativ auf die Bildqualität auswirkt. Zweitens führt die absorbierte Energie, die durchaus in die Größenordnung von 1 W/kg Körpergewicht kommt, zu einer lokalen Erwärmung. Diese Energie stellt etwa die Grenze dessen dar, was vom medizinischen Standpunkt aus noch als sicher unschädlich angenommen wird. Andererseits ist es jedoch sehr erwünscht, zur Erhöhung der Meßempfindlichkeit und zur Verkürzung der Aufnahmezeit eines Kernresonanz-Tomogramms die wirksame magnetische Feldstärke des Hochfrequenz-Magnetfeldes zu erhöhen.

Da die dielektrischen Verluste sowohl mit der Feldstärke als auch mit der Frequenz des Hochfrequenzfeldes zunehmen, stellt die o.g. praktische Obergrenze von 1,5 Tesla, entsprechend 60 MHz Protonen-Resonanzfrequenz, daher einen Kompromiß dar, zwischen der im Prinzip angestrebten (noch) höheren Magnetfeldstärke bzw. Meßfrequenz und derjenigen, die aufgrund der dielektrischen Verluste noch akzeptabel ist. Wenn es gelingt, diese zu reduzieren, so ließe sich die Kernspin-Tomographie auf höhere Felder ausdehnen und damit die für die medizinische Diagnostik äußerst wichtigen Parameter, die räumliche Auflösung und die Meßzeit, noch weiter verbessern.

Bei den eingangs im einzelnen erläuterten diversen Probenköpfen des Standes der Technik ist diesem Gesichtspunkt überhaupt keine Beachtung geschenkt worden. So durchsetzen die Feldlinien des elektrischen Hochfrequenz-Feldes bei Resonatoren mit axialer Führung des Hochfrequenz-Stromes (US-PS 4 751 464 und EP-OS 160 942) z.B. den Probenraum in einer Richtung senkrecht zur Längsachse, so daß der zu messende Körper diesen Feldlinien in vollem Umfange ausgesetzt wird.

Vor allem aber hat die bekannte Anordnung der DE-OS 35 12 682 den Nachteil, daß sie als "offene" Anordnung arbeitet, also in der Praxis als Antenne, bei der die Feldlinien des elektrischen und des magnetischen Hochfrequenz-Feldes sich weit außerhalb der Spulenanordnung mehr oder weniger zufällig über Bauteile in der Umgebung schließen. Mit derartigen "offenen" Spulenanordnungen ist der Wunsch nach kompakter Bauweise nicht zu erfüllen, weil eine Konzentration der Feldlinien im Spuleninneren infolge der "offenen" Bauweise nicht möglich ist. Bei dieser Bauweise muß daher die gewünschte elektrische bzw. magnetische Feldstärke durch Erhöhung des Hochfrequenz-Stromes mit allen damit verbundenen Nachteilen erreicht werden.

Der Erfindung liegt demgegenüber die Aufgabe zugrunde, einen Probenkopf der eingangs genannten Art dahingehend weiterzubilden, daß bei kleiner Bauweise ein Probenraum zur Verfügung gestellt wird, in dem die elektrische Hochfrequenz-Feldstärke bei unverändert hoher magnetischer Hochfrequenz-Feldstärke nur einen minimalen Wert annimmt.

Diese Aufgabe wird erfindungsgemäß dadurch gelöst, daß die Hochfrequenz-Spule zusammen mit einem Außenmantel eine Einheit bildet und daß die Anzahl der induktiven und der kapazitiven Abschnitte so bemessen ist, daß sie gerade unterhalb desjenigen Grenzwertes liegt, bei dessen Überschreitung die Verteilung der Feldlinien des von der Hochfrequenz-Spule erzeugten elektrischen Hochfrequenz-Feldes von einer ersten Verteilung, bei der sich von jedem induktiven Abschnitt zur Achse eine Ebene erstreckt, in der die Stärke des elektrischen Hochfrequenz-Feldes gleich Null ist, in eine zweite Verteilung umkippt, bei der die Stärke des elektrischen Hochfrequenz-Feldes unabhängig von der Anzahl der induktiven Abschnitte im wesentlichen rotationssymmetrisch um die Achse und linear von der Achse zur Hochfrequenz-Spule hin ansteigend verläuft.

Die der Erfindung zugrundeliegende Aufgabe wird auf diese Weise vollkommen gelöst.

Im Rahmen der vorliegenden Erfindung wurde nämlich überraschenderweise gefunden, daß bei einer Erhöhung der Anzahl der induktiven Abschnitte und damit auch der kapazitiven Abschnitte nicht nur eine Erhöhung der Güte des Kreises eintritt, es hat sich vielmehr ergeben, daß bei einer Zunahme der Anzahl der Abschnitte sich eine Verteilung der Feldlinien des elektrischen Hochfrequenz-Feldes ergibt, bei der im Spulenzentrum nur noch eine sehr geringe elektrische Feldstärke vorhanden ist. Allerdings hat sich im Verlaufe der zugehörigen Überlegungen und Untersuchungen ergeben, daß die Größe der Anzahl der kapazitiven und induktiven Abschnitte nicht beliebig erhöht werden kann. Es existiert vielmehr ein Grenzwert für die Anzahl, bis zu dem sich die elektrische Feldstärke im Spulenzentrum mehr und mehr vermindert, bis plötzlich bei einer weiteren Erhöhung der Anzahl die Verteilung der Feldlinien des elektrischen Hochfrequenz-Feldes vollständig umkippt und sich bei jeder höheren Anzahl der Abschnitte eine im wesentlichen gleichbleibende entartete Verteilung der genannten Feldlinien einstellt. Bei dieser Verteilung ist zwar der Betrag der elektrischen Feldstärke im exakten Zentrum der Spule ebenfalls null, die elektrische Feldstärke steigt jedoch von dort nahezu linear an bis hin zu den die Spule bildenden induktiven und kapazitiven Abschnitten.

Der Erfindung liegt daher der Gedanke zugrunde, die Anzahl der kapazitiven und induktiven Abschnitte bis nahe unterhalb des genannten Grenzwertes einzustellen, so daß die großräumige Verminderung des elektrischen Hochfrequenz-Feldes im Inneren der Spule bestmöglich ausgenutzt werden kann.

Bei praktischen Versuchen hat sich ergeben, daß in einem Bereich der Spulenmitte bis etwa zu einem Drittel des Radius auf diese Weise eine Verminderung der elektrischen Feldstärke um etwa eine Großenordnung erreicht werden kann. Da, wie erwähnt, die dielektrischen Verluste im menschlichen Körper sich jedoch mit dem Quadrat der elektrischen Feldstärke ändern, ist leicht ersichtlich, daß die Erfindung zu einer drastischen Verminderung der dielektrischen Verluste im menschlichen Körper bei Kernresonanz-Ganzkörper-Tomographie-Messungen oder bei ortsabhängigen in-vivo Kernresonanz-Spektroskopie-Messungen führt.

Bei dem erfindungsgemäßen Vorgehen bleibt nämlich, was weiterhin überraschend ist, die Verteilung der Feldlinien des magnetischen Hochfrequenz-Wechselfeldes nahezu unverändert, die den Innenraum der Hochfrequenz-Spule weiterhin axial und mit sehr hoher Homogenität durchsetzen.

Die Erfindung eröffnet der Kernresonanz-Ganzkörper-Tomographie und der ortsabhängigen in-vivo Kernresonanz-Spektroskopie damit ganz neue Einsatzmöglichkeiten, weil die Stärke des magnetischen Hochfrequenz-Wechselfeldes um etwa eine Größenordnung erhöht werden kann, ohne daß sich gegenüber herkömmlichen Probenköpfen die dielektrischen Verluste im zu untersuchenden menschlichen Körper erhöhen.

Ein weiterer überraschender Erfolg stellt sich bei der Erfindung dadurch ein, daß die Hochfrequenzspule und der Außenmantel eine Einheit bilden, weil hierdurch nämlich eine Feldkonzentration stattfindet, bei der die aus der Hochfrequenz-Spule austretenden Feldlinien auf den Innenraum des Probenkopfes beschränkt bleiben und keine Strahlungsverluste auftreten. Diese Maßnahme führt zu sonst nicht erreichbaren Kreisgüten, wie weiter unten anhand von Meßwerten noch gezeigt werden wird.

Im Gegensatz zu den aus der Mikrowellentechnik bekannten Resonatoren der Elektronenspinresonanz-Spektroskopie braucht dabei auch nur ein relativ kleiner Abstand zwischen der Außenseite der Hochfrequenz-Spule und der Innenseite des Außenmantels eingehalten zu werden. Die Baugröße des erfindungsgemäßen Probenkopfes ist daher äußerst gering, so daß sich der erfindungsgemäße Probenkopf auch für solche Tomographie-Geräte eignet, die mit sehr hohen magnetischen Feldern arbeiten.

Es wurde bereits erwähnt, daß eine Erhöhung der Anzahl der induktiven und kapazitiven Abschnitte auch eine Erhöhung der Güte bedeutet, weil bei einer Erhöhung der Anzahl der kapazitiven Abschnitte die wirksame Länge der induktiven Abschnitte für den Hochfrequenz-Strom und damit auch die Ohm'schen Verluste geringer werden.

Die Erfindung erreicht damit durch verhältnismäßig einfache Maßnahmen mit einem Schlag drei wesentliche Vorteile gegenüber herkömmlichen Probenköpfen, die nicht vorhersehbar waren.

Bei einer bevorzugten Ausgestaltung der Erfindung sind die kapazitiven Abschnitte als Spalte ausgebildet, die parallel zu den Feldlinien des Hochfrequenz-Magnetfeldes verlaufen.

Diese Maßnahme hat den Vorteil, daß eine definierte Feldverteilung erzielt wird, bei der die Feldlinien des elektrischen Hochfrequenz-Magnetfeldes exakt unter 90° zu den Feldlinien des Konstant-Magnetfeldes verlaufen.

Bevorzugt ist dabei, wenn die Spalte mit einem Dielektrikum ausgefüllt sind.

Diese Maßnahme hat den Vorteil, daß die induktiven Abschnitte mechanisch überbrückt sind und damit auch die Stabilität der Anordnung erhöht wird.

Bevorzugt ist ferner bei den vorstehend genannten Ausführungsbeispielen, wenn die metallischen Bänder an ihren an die Spalte angrenzenden Rändern vom Innenraum der Hochfrequenz-Spule weg gebogen sind, derart, daß die kapazitiven Abschnitte außerhalb des Innenraumes liegen.

Diese an sich bekannte Maßnahme hat den Vorteil, daß durch das Verbringen der kapazitiven Abschnitte aus dem Innenraum heraus die elektrische Feldstärke im Innenraum weiter vermindert werden kann.

Bei Ausführungsbeispielen der Erfindung sind die Bänder eben.

Diese Maßnahme hat den Vorteil, daß die Hochfrequenz-Spule nach Art von Vielecken aufgebaut werden kann, was im Einzelfall zu konstruktiven Vorteilen führt. Auch sind ebene Bänder leichter und kostengünstiger herzustellen.

Alternativ dazu ist es jedoch auch möglich, gewölbte Bänder zu verwenden, wobei die Bänder vorzugsweise in der Richtung des Hochfrequenz-Stromes gebogen sind.

Auf diese Weise können ringförmige Hochfrequenz-Spulen realisiert werden, wie dies an sich bekannt ist. Wenn man den Bändern alternativ oder zusätzlich eine Wölbung quer zu ihrer Längsrichtung verleiht, so entstehen mechanisch besonders stabile Gebilde.

Bei Ausführungsbeispielen der Erfindung sind die metallischen Bänder an den kapazitiven Abschnitten starr miteinander verbunden.

Diese Maßnahme hat, wie bereits weiter oben erwähnt, den Vorteil, daß besonders stabile Hochfrequenz-Spulen entstehen, die selbsttragend sein können.

Bei Varianten dieses Ausführungsbeispiels können die metallischen Bänder mittels eines Klebstoffes miteinander verklebt werden, wobei der Klebstoff vorzugsweise ein Dielektrikum bildet. Auf diese Weise wird zugleich eine mechanische Verbindung und eine elektrische Verbesserung in der weiter oben beschriebenen Weise erreicht.

Bei alternativen Ausführungsbeispielen ist es jedoch auch möglich, die metallischen Bänder miteinander zu verschrauben, wozu selbstverständlich nicht-leitfähige Schrauben, beispielsweise Kunststoffschrauben oder PTFE-Schrauben, verwendet werden können.

Bei einer weiteren Gruppe von Ausführungsbeispielen liegt die Breite der Spalte in Richtung des Hochfrequenz-Stromes zwischen 0,1 % und 2 %, vorzugsweise bei 0,5 % des Umfanges der Hochfrequenz-Spule.

Dieser Wertebereich hat sich in der Praxis als besonders vorteilhaft erwiesen, weil einerseits die gewünschte Verteilung der induktiven und der kapazitiven Elemente erreicht werden kann, andererseits aber die kapazitiven Abschnitte in Richtung des Hochfrequenz-Stromes so breit wie möglich gehalten werden, um die Ohm'schen Verluste in den induktiven Bereichen zu senken.

Bei einer weiteren Gruppe von Ausführungsbeispielen beträgt eine erste Abmessung der metallischen Bänder in Richtung des Hochfrequenz-Stromes nicht mehr als das Vierfache einer zweiten, dazu senkrechten Abmessung.

Diese Maßnahme hat den Vorteil, daß durch Verwendung besonders "breiter" Bänder, in einer Richtung quer zur Ausbreitungsrichtung des Hochfrequenz-Stromes gesehen, die Ohm'schen Verluste ebenfalls niedrig gehalten werden können, weil der wirksame Querschnitt der Bänder groß gewählt ist.

Bei einer anderen Gruppe von Ausführungsbeispielen liegt eine zur Richtung des Hochfrequenz-Stromes senkrechte Abmessung der metallischen Bänder zwischen 10 % und 50 %, vorzugsweise bei 20 % des Durchmessers der Hochfrequenz-Spule.

Auch dieser Wertebereich hat sich in der Praxis als besonders vorteilhaft erwiesen, insbesondere dann, wenn Anordnungen mit mehreren Einzelspulen verwendet werden sollen.

Bei Ausführungsbeispielen der Erfindung weist der Außenmantel eine im wesentliche kreiszylindrische Form auf und umgibt die Hochfrequenz-Spule in einem Abstand, der zwischen 5 % und 20 %, vorzugsweise bei 10 % des Durchmessers der Hochfrequenz-Spule liegt.

Durch den hier angegebenen Wertebereich kann in besonders deutlicher Weise der bereits weiter oben angedeutete Vorteil erreicht werden, daß mit einem nur minimalen Zwischenraum zwischen der Hochfrequenz-Spule und dem Außenmantel eine genügende Rückführung und damit Konzentration der Feldlinien möglich ist. Die Baugröße des Gesamt-Resonators wird damit so klein wie nur irgend möglich gehalten.

Bei einer weiteren Gruppe von Ausführungsbeispielen umfaßt der Probenkopf zwei Hochfrequenz-Spulen in Helmholtz-Anordnung, wie dies an sich bekannt ist.

Besonders bevorzugt ist ferner, wenn der Probenkopf vier Hochfrequenz-Spulen umfaßt, von denen jeweils zwei ein Paar in Helmholtz-Anordnung bilden und die Achsen der Paare aufeinander senkrecht stehen.

Eine derartige Anordnung hat den wesentlichen Vorteil, daß sie als sogenannte Bloch'sche Anordnung Induktionsmessungen gestattet, bei denen die Kernspins, die über das eine Paar der Spulen angeregt werden, das Meßsignal in das andere Spulenpaar induzieren und zugleich eine extreme elektrische Entkopplung zwischen den beiden Spulenpaaren gegeben ist. Andererseits hat eine derartige Anordnung aber auch den Vorteil, daß die zu untersuchende Substanz gleichzeitig mit zwei Anregungssignalen unterschiedlicher Phasenlage beaufschlagt werden kann, so daß in der Meßsubstanz ein zirkularpolarisiertes Anregungsfeld entsteht und eine Detektion des Meßsignales mit Quadratur-Empfänger möglich wird.

Bei den vorstehend genannten Ausführungsbeispielen mit Helmholtz-Anordnung ist besonders bevorzugt, wenn die Hochfrequenz-Spulen in an sich bekannter Weise als Sattelspulen ausgebildet sind.

Diese Maßnahme hat nämlich den Vorteil, daß der Zugang zum Innenraum der Spule erleichtert wird, weil bei Probenköpfen der hier interessierenden Art die Hochfrequenz-Spule mit ihrer Längsachse quer zur Richtung des Konstant-Magnetfeldes steht und bei Verwendung von supraleitenden Solenoid-Spulen zur Erzeugung des Konstant-Magnetfeldes damit ein Zugang aus einer Richtung senkrecht zur Längsachse der Hochfrequenz-Spule erforderlich ist.

Bei Anordnungen mit zwei Paaren von Helmholtz-Spulen ist weiterhin besonders bevorzugt, wenn die Sattelspulen derart ausgebildet und zueinander angeordnet sind, daß jede Sattelspule eines Paares mit mindestens einem Punkt an den beiden Sattelspulen des jeweils anderen Paares anliegt und dort befestigt ist.

Diese Maßnahme hat den Vorteil, daß eine selbststragende Anordnung der insgesamt vier Hochfrequenz-Spulen entsteht, die sich räumlich an insgesamt acht Punkten berühren und damit ein stabiles Fachwerk bilden.

Ein besonders bevorzugtes Ausführungsbeispiel der Erfindung wird dadurch gebildet, daß die Sattelspulen zwei kreisringsegmentförmige Bänder sowie zwei langgestreckte, vorzugsweise in Längs- und/oder Querrichtung gewölbte Bänder umfaßt, die mit ihren freien Enden unter einem Winkel von 90° zu den kreisringsegmentförmigen Bändern hin verlaufen.

Diese Merkmale haben den Vorteil, daß eine besonders einfache Anordnung entsteht, die bei supraleitenden Magnetsystemen mit üblichen Kryostaten einsetzbar ist.

Weiterhin ist noch bevorzugt, wenn mindestens eine als Erdung dienende Leitung für den Hochfrequenz-Strom als Halterung für die metallischen Bänder an dem Abschirmgehäuse ausgebildet ist.

Diese Maßnahme hat den Vorteil, daß eine weitere Erhöhung der Stabilität möglich ist, ohne zusätzliche Halterungen verwenden zu müssen, die den Verlauf der Felder stören könnten. Die Symmetrie der Hochfrequenz-Spulen des Probenkopfes und die Verteilung des elektrischen Hochfrequenz-Feldes bringen es mit sich, daß im Inneren des Probenkopfes Ebenen auftreten, an denen die elektrische Hochfrequenz-Feldstärke Null ist. Dort kann man also unbedenklich erden, und dies ist deswegen empfehlenswert, um bei der großen Ausdehnung des Probenkopfes sicher zu sein, daß in dem Kreis nur der gewünschte Schwingungsmode angeregt wird. Diese Erdungen können auch gleichzeitig als Halterungen dienen.

Schließlich kann der erfindungsgemäße Probenkopf vorteilhaft als Oberflächenspule verwendet werden.

Weitere Vorteile ergeben sich aus der Beschreibung und der beigefügten Zeichnung.

Ausführungsbeispiele der Erfindung sind in der Zeichnung dargestellt und werden in der nachfolgenden Beschreibung näher erläutert. Es zeigen:

Fig. 1     eine perspektivische Darstellung eines Probenkopfes, teilweise aufgebrochen, mit einer Hochfrequenz-Spule, bestehend aus einer zweifach geschlitzten Anordnung mit hohlzylindersegmentförmigen Elementen und mit einem Außenmantel, der zusammen mit der Hochfrequenz-Spule eine integrierte Einheit bildet;

Fig. 2     eine Draufsicht auf die Anordnung gemäß Fig. 1;

Fig. 3     einen weiteren Probenkopf, ähnlich Fig. 1, jedoch mit vierfach geschlitzter Hochfrequenz-Spule;

Fig. 4     eine Ansicht wie Fig. 2, jedoch für den Probenkopf der Fig. 3;

Fig. 5     einen Probenkopf ähnlich der Fig. 1 und 3, jedoch mit einer achtfach geschlitzten Hochfrequenz-Spule;

Fig. 6     eine Ansicht, ähnlich denen der Fig. 2 und 4, jedoch für den Probenkopf gemäß Fig. 5;

Fig. 7     einen weiteren Probenkopf, ähnlich den Fig. 1, 3 und 5, jedoch mit sechzehnfach geschlitzter Hochfrequenz-Spule;

Fig. 8     eine Ansicht, ähnlich den Fig. 2, 4 und 6, jedoch für den Probenkopf der Fig. 7;

Fig. 9     in perspektivischer Ansicht den Verlauf des Betrages der elektrischen Feldstärke über einer radialen Querschnittsfläche der Hochfrequenz-Spule beim Probenkopf der Fig. 1;

Fig. 10    eine Darstellung ähnlich Fig. 9, jedoch für den Probenkopf gemäß Fig. 3;

Fig. 11    eine Darstellung ähnlich den Fig. 9 und 10, jedoch für den Probenkopf gemäß Fig. 5;

Fig. 12    eine Darstellung ähnlich den Fig. 9, 10 und 11, jedoch für den Probenkopf gemäß Fig. 7;

Fig. 13    eine graphische Darstellung von in der Praxis gemessenen Meßwerten zur Erläuterung der Abhängigkeit der elektrischen Feldstärke in einem vorgegebenen Abstand von der Achse einer Hochfrequenz-Spule in Resonatoren nach Art der Fig. 1, 3, 5 und 7 von der Anzahl der Schlitze in der Hochfrequenz-Spule;

Fig. 14    eine graphische Darstellung von in der Praxis gemessenen Meßwerten zur Erläuterung der Abhängigkeit der Güte von der Anzahl der Schlitze bei Hochfrequenz-Spulen der Resonatoren gemäß den Fig. 1, 3, 5 und 7;

Fig. 15    eine perspektivische Darstellung eines weiteren Probenkopfes mit zwei Hochfrequenz-Spulen in Helmholtz-Anordnung in einem Konstant-Magnetfeld eines Kernresonanz-Tomographen;

Fig. 16    eine perspektivische Darstellung, teilweise aufgebrochen, eines betriebsfertigen Resonators ähnlich der in Fig. 3 und 4 gezeigten Bauart;

Fig. 17    eine radiale Schnittdarstellung durch den Resonator gemäß Fig. 16;

Fig. 18    eine perspektivische Ansicht von zwei Paaren von Hochfrequenz-Spulen zur Durchführung von Experimenten mit zirkularer Polarisation und Quadrator-Detektion oder zur Durchführung von Induktions-Experimenten;

Fig. 19    eine perspektivische Darstellung eines weiteren Ausführungsbeispiels eines Probenkopfes, bei dem die Hochfrequenz-Spule nach Art eines Vielecks mit ebenen Bändern gebildet ist;

Fig. 20    eine Seitenansicht einer Hochfrequenz-Spule für einen weiteren Probenkopf, die nach Art eines Sechzehn-Ecks mit ebenen Bändern aufgebaut ist;

Fig. 21    eine perspektivische Ansicht der in Fig. 20 gezeigten Hochfrequenz-Spule;

Fig. 22    einen Probenkopf nach Art desjenigen der Fig. 18, jedoch bestehend aus vier ineinander verschachtelten und aneinander befestigten Hochfrequenz-Spulen gemäß Fig. 20 und 21;

Fig. 23    ein Detail, darstellend eine erste Ausführungsform eines induktiven Abschnittes für eine Hochfrequenz-Spule eines erfindungsgemäßen Probenkopfes;

Fig. 24       eine Variante zum Detail der Fig. 23;

Fig. 25       eine weitere Variante zum Detail der Fig. 23;

Bei der Entwicklüng großräumiger Probenköpfe bzw. Resonatoren für die Kernresonanz-Tomographie werden Frequenzen von 6 bis 60 MHz, entsprechend 50 - 5 m Wellenlänge, und für die ortsabhängige in-vivo Spektroskopie Frequenzen von 80 - 200 MHz entsprechend ca. 4 - 1,5 m Wellenlänge, im Probenkopf benötigt. Mit abnehmender Wellenlänge wird aber die Konstruktion geeigneter Probenköpfe bzw. der darin verwendeten Resonatoren schwieriger, und außerdem nimmt die für das im Meßraum angeordnete Meßobjekt schädliche Absorption der Hochfrequenz-Energie zu. Diese Absorption wird durch die Leitfähigkeit des Meßobjektes, die im elektrischen Hochfrequenz-Feld im Meßraum einen Verluststrom verursacht, hervorgerufen.

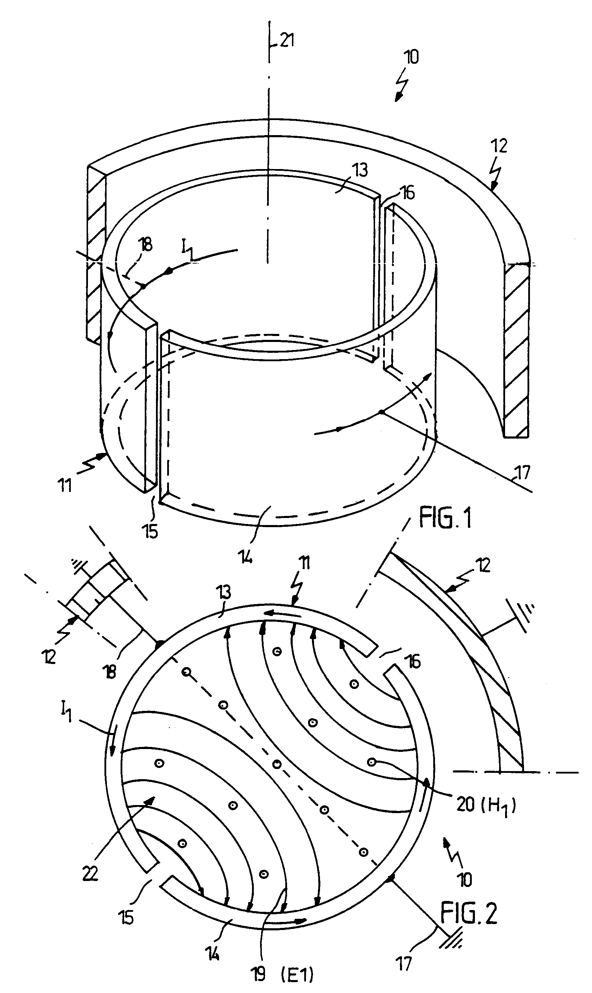

Zur Erläuterung dieser Verhältnisse zeigen die Fig. 1 und 2 einen ersten Probenkopf 10 mit einer Hochfrequenz-Spule 11, die von einem zylindrischen Außenmantel 12 umgeben ist.

Die Hochfrequenz-Spule 11 besteht aus zwei Bändern 13 und 14, die als Segmente eines Hohlzylinders bzw. zwei Halbschalen ausgebildet sind. Zwischen den Bändern 13 und 14 befindet sich an deren freien Enden jeweils ein Spalt 15 bzw. 16. Eine als Erdung dienende Leitung 17 ist radial an das erste Band 13 und eine weitere als Erdung dienende Leitung 18 ist radial an das zweite Band 14 angeschlossen.

Hochfrequenztechnisch gesehen besteht die Hochfrequenz-Spule 11 aus induktiven Abschnitten, die von den metallischen Bändern 13, 14 gebildet werden, sowie aus kapazitiven Abschnitten, gebildet durch die Spalte 15 und 16.

Die Hochfrequenz-Spule 11 wird in an sich bekannter Weise mit Hochfrequenz-Energie versorgt, indem eine übliche Ankopplung verwendet wird, die in Fig. 1 ebenso wie in den folgenden Figuren der Übersichtlichkeit halber fortgelassen ist. Die Hochfrequenz-Ankopplung kann in herkömmlicher Weise auf induktivem Wege über eine Schleife im Hochfrequenz-Magnetfeldraum vorgenommen werden. Die Struktur des Schwingkreises wird dann das gewünschte Hochfrequenz-Magnetfeld erzwingen, insbesondere bei der beschriebenen symmetrischen Erdung der Kreise über die Leitungen 17 und 18.

Bezeichnet man die Achse der Hochfrequenz-Spule 11 mit 21, so ergibt sich eine Verteilung 22 der Feldlinien 19, 20, bei der die Feldlinien 20 des magnetischen Hochfrequenz-Feldes $H_1$ parallel zur Achse 21 und die Feldlinien 19 des elektrischen Hochfrequenz-Feldes $E_1$ senkrecht zur Achse 21 verlaufen. Die Feldlinien 20 des magnetischen Hochfrequenz-Feldes $H_1$ durchsetzen den Innenraum der Hochfrequenz-Spule 11 dabei im wesentlichen homogen, während die Feldlinien 19 des elektrischen Hochfrequenz-Feldes $E_1$ in einer Radialebene eine inhomogene Verteilung 22 haben, weil sie jeweils von einer nicht-ebenen Elektrode, nämlich dem ersten Band 13, zu einer weiteren nichtebenen Elektrode, nämlich dem zweiten Band 14, verlaufen.

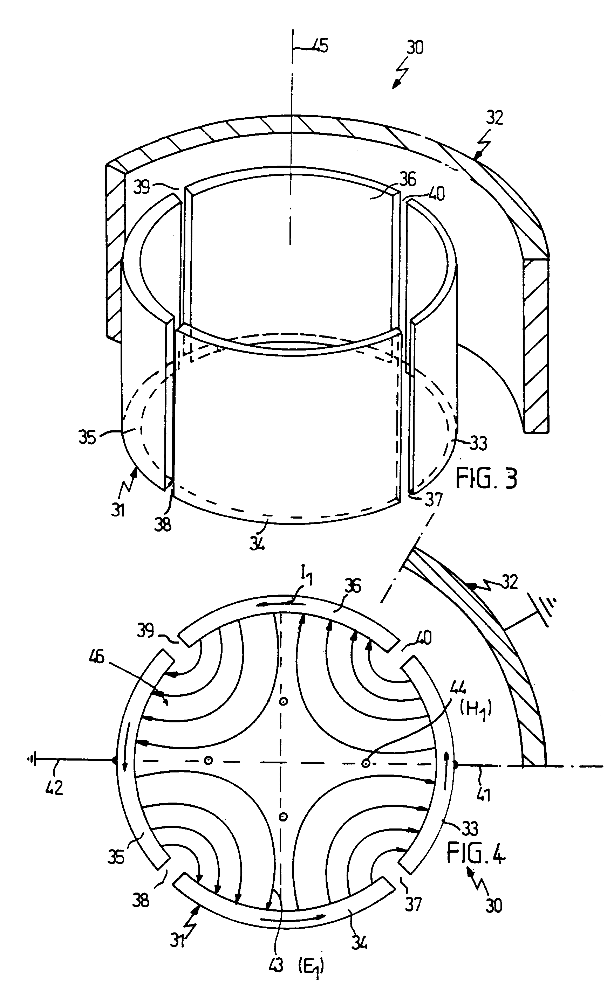

In den Fig. 3 und 4 sind die entsprechenden Verhältnisse für einen zweiten Probenkopf 30 dargestellt, bei dem wiederum eine Hochfrequenz-Spule 31 in einem Außenmantel 32 untergebracht ist.

Beim Probenkopf 30 weist die Hochfrequenz-Spule 31 jedoch vier Bänder 33 bis 36 auf, die zwischen sich Spalte 37 bis 40 einschließen. Wie aus Fig. 4 deutlich wird, sind Erdleitungen 41, 42 jeweils nur an eines der Bänder 33 und 35 angeschlossen. Die Feldlinien 43 des elektrischen Hochfrequenz-Feldes $E_1$ und die Feldlinien 44 des magnetischen Hochfrequenz-Feldes $H_1$ verlaufen wiederum senkrecht bzw. parallel zu einer Achse 45 und haben die aus Fig. 4 ersichtliche Verteilung 46.

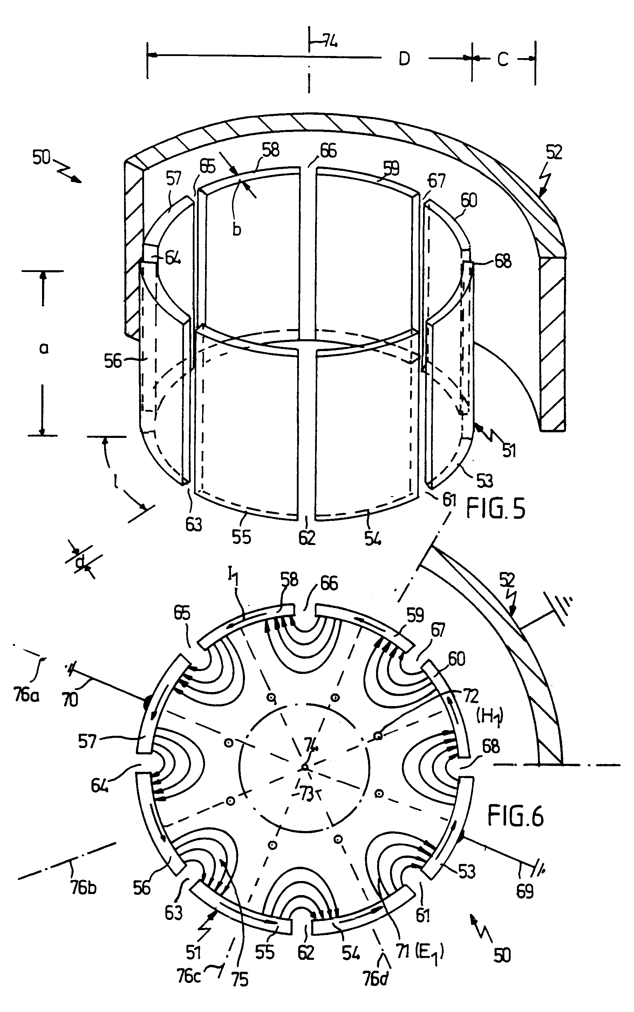

In den Fig. 5 und 6 sind die entsprechenden Verhältnisse für einen dritten Probenkopf 50 dargestellt, bei dem wiederum eine Hochfrequenz-Spule 51 von einer zylindrischen Außenmantel 52 umgeben ist.

Beim Probenkopf 50 besteht die Hochfrequenz-Spule 51 jedoch aus acht Bändern 53 bis 60 mit acht Spalten 61 bis 68, und Erdleitungen 69 und 70 sind im Bild nur an das Band 53 bzw. das gegenüberliegende Band 57 angeschlossen; sie können aber auch an vier Bänder oder alle Bänder angeschlossen sein.

Feldlinien 71 des elektrischen Hochfrequenz-Feldes $E_1$ und Feldlinien 72 des magnetischen Hochfrequenz-Feldes $H_1$ haben die aus Fig. 6 erkennbare Verteilung 56 und verlaufen senkrecht bzw. parallel zur Achse 24 der Hochfrequenz-Spule 51.

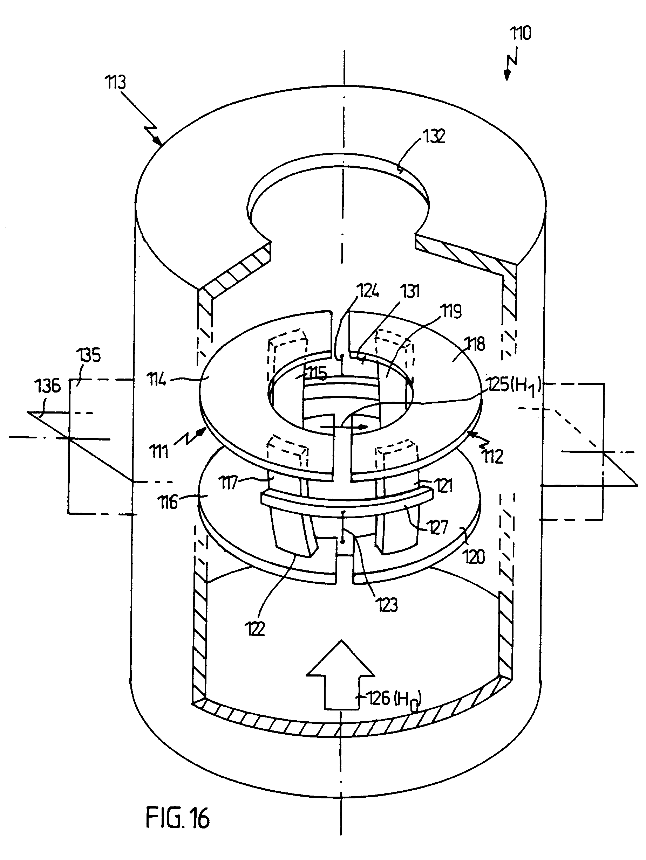

Aus der Verteilung 75 des elektrischen Hochfrequenz-Feldes $E_1$ ergibt sich, daß je nach Spaltzahl n eine Anzahl n/2 von Ebenen auftritt, in denen die elektrische Hochfrequenz-Feldstärke $E_1$ Null ist. Dies konnte in praktischen Versuchen, z.B. bei einer Anordnung mit vier Spalten meßtechnisch nachgewiesen werden. Diese Messungen sind in Fig. 16 veranschaulicht.

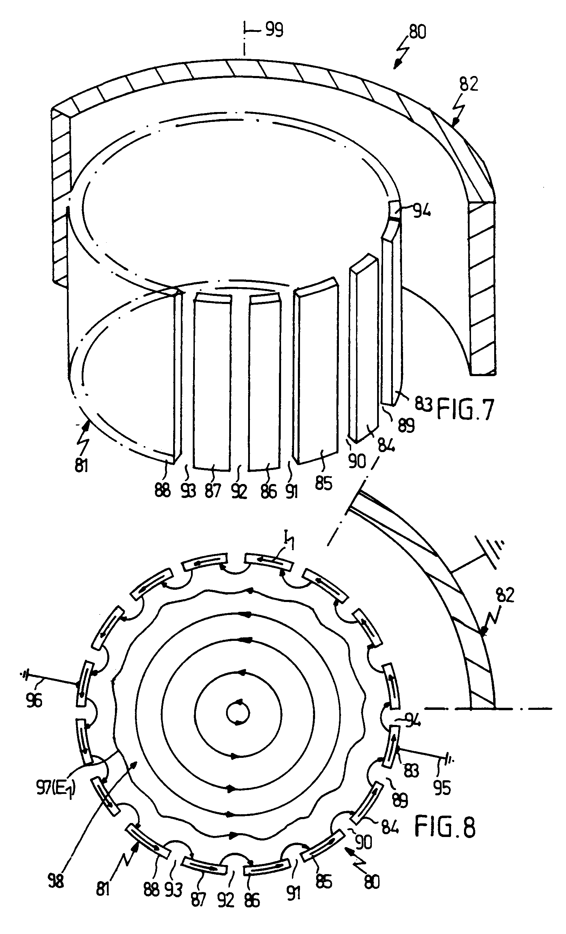

Die Fig. 7 und 8 zeigen nun einen vierten Probenkopf 80 mit einer Hochfrequenz-Spule 81, die wiederum in einem zylindrischen Abschirmgehäuse 82 untergebracht ist.

Die Hochfrequenz-Spule 81 umfaßt nunmehr sechzehn Bänder, von denen einige in den Fig. 7 und 8 mit 83 bis 88 bezeichnet sind. Entsprechend sind sechzehn Spalte 89 bis 94 vorgesehen.

Erdleitungen 95 und 96 können wiederum z.B. an diametral gegenüberliegende Bänder 83 usw. angeschlossen sein, wie oben zu Fig. 6 erläutert.

Die Feldlinien 97 des elektrischen Hochfrequenz-Feldes $E_1$ verlaufen wiederum senkrecht zur Achse 99 der Hochfrequenz-Spule 81.

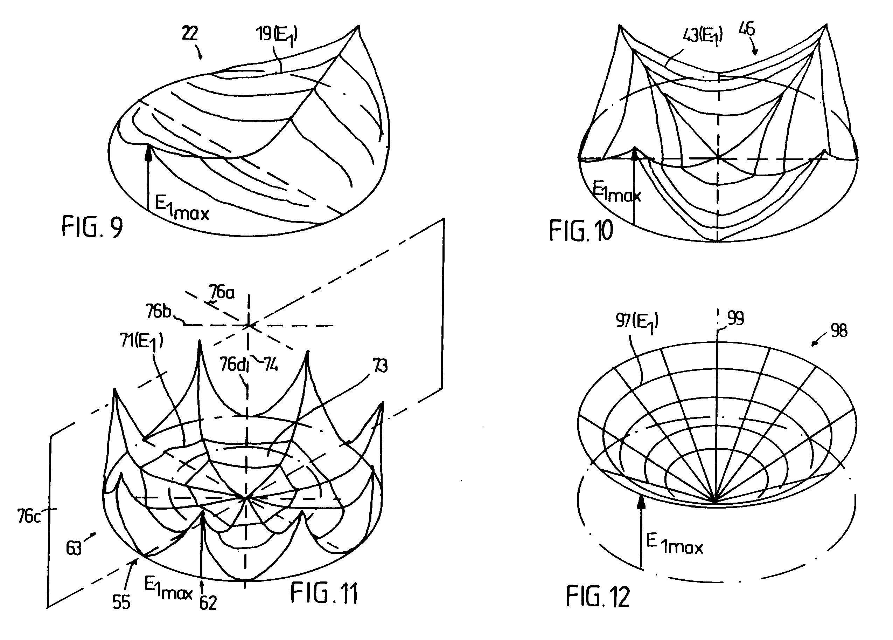

In den Fig. 9 bis 12 sind nun im Vergleich nochmals die Feldlinien 19 bzw. 43 bzw. 71 bzw. 97 für die Verteilungen 22 bzw. 46 bzw. 75 bzw. 98 des elektrischen Hochfrequenz-Feldes $E_1$ für die Probenköpfe 10 bzw. 30 bzw. 50 bzw. 80 dargestellt.

Man erkennt aus den Fig. 9 bis 11 deutlich, daß sich die Verteilung 22 für den Fall der zweifach geschlitzten Hochfrequenz-Spule 11 regular zunächst in die Verteilung 46 für den Fall der vierfach geschlitzten Hochfrequenz-Spule 31 und dann in die Verteilung 75 für den Fall der achtfach geschlitzten Hochfrequenz-Spule 51 ändert.

In den Fällen, der Fig. 9, 10 und 11 sind jeweils gestrichelt angedeutete Ebenen definiert, die jeweils von der Mitte eines induktiven Abschnitts zur Achse führen und auf denen die elektrische Feldstärke insgesamt den Betrag Null hat. Im Fall der zweifach geschlitzten Hochfrequenz-Spule (Fig. 9) existiert eine solche Ebene, im Falle der vierfach geschlitzten Spule (Fig. 10) gibt es zwei solche Ebenen und im Falle der achtfach geschlitzten Spule (Fig. 11) sind deutlich vier derartige Ebenen zu erkennen, die mit 76a, 76b, 76c und 76d bezeichnet sind. Der Klarheit halber ist die Ebene 76c deutlich herausgezeichnet und man erkennt, daß sie von der Mitte des induktiven Abschnitts, der durch das dritte Band 55 symbolisiert wird, zur Achse 74 führt und nur Raumpunkte enthält, in denen die elektrische Feldstärke den Betrag Null hat.

Es darf an dieser Stelle angemerkt werden, daß die vorliegenden Erläuterungen nicht auf den Fall beschränkt sind, daß die Anzahl der Bänder bzw. Spalte eine Potenz von 2 ist, entsprechende Überlegungen lassen sich vielmehr auch für sechsfach, zehnfach und evtl. noch zwölffach usw. geschlitzte Hochfrequenz-Spulen anstellen. Im Prinzip sind auch ungerade Spaltzahlen (drei-, fünf-, sieben-, neun-, elffach) möglich, diese Anordnungen dürften aufgrund der geringeren Symmetrie im allgemeinen aber weniger vorteilhaft sein.

In den Darstellungen der Fig. 9 bis 11 ist jeweils der Betrag der elektrischen Feldstärke dargestellt.

Vergleicht man nun die Verteilungen 22, 46 und 75 der Fig. 9, 10 und 11, so ergibt sich deutlich, daß mit zunehmender Anzahl der Abschnitte der Hochfrequenz-Spulen der zentrale Bereich der Spule einen immer flacheren Verlauf der elektrischen Feldstärke zeigt. In Fig. 11 ist dies mit einem Bereich 73 angedeutet, der auch in Fig. 6 eingezeichnet ist und in dem die elektrische Feldstärke auf einen Minimalwert abgefallen ist.

Die Verminderung der elektrischen Feldstärke im zentralen Bereich 73 kann man sich so erklären, daß die Feldlinien 19 bzw. 43 bzw. 71 des elektrischen Hochfrequenz-Feldes $E_1$ nicht beliebig scharf gekrümmt verlaufen können. Infolge dieser begrenzten Krümmung der genannten Feldlinien reichen diese bei zunehmender Anzahl der kapazitiven und induktiven Abschnitte immer weniger weit in den Innenraum der Hochfrequenz-Spule hinein, wie deutlich auch aus einem Vergleich der Fig. 2, 4 und 6 erkennbar ist, da die von den kapazitiven bzw. induktiven Abschnitten definierten Sektoren der Querschnittsfläche einen immer kleiner werdenden Zentrumswinkel haben.

Betrachtet man nun jedoch die Fig. 8 und 12, so wird deutlich, daß diese Entwicklung nicht unbegrenzt fortsetzbar ist.

Wird nämlich die Anzahl der induktiven bzw. der kapazitiven Abschnitte der Hochfrequenz-Spule über einen Grenzwert hinaus weiter erhöht, im Beispielsfall der Fig. 7 und 8 auf sechzehn, so zeigt sich, daß die Verteilung 98 der Feldlinien 97 des elektrischen Hochfrequenz-Feldes $E_1$ sich sprungartig ändert und nunmehr die aus Fig. 12 ersichtliche entartete Form annimmt. Bei dieser Verteilung 98 ist zwar die elektrische Feldstärke im exakten Zentrum der Hochfrequenz-Spule 81, d.h. in der Achse 99, ebenfalls gleich null, die elektrische Feldstärke steigt vom Zentrum jedoch praktisch linear und in rotationssymmetrischer Verteilung 98 zur Peripherie der Hochfrequenz-Spule 81 hin an. Die Verteilung 98 ändert sich oberhalb des genannten Grenzwertes praktisch nicht mehr in Abhängigkeit von der Anzahl der Abschnitte.

Im Gegensatz zur Verteilung 75 bei achtfach geschlitzter Hochfrequenz-Spule 51 gemäß Fig. 5 und 6 existiert somit kein zentraler Bereich mehr, in dem die elektrische Feldstärke in einem größeren Raum sehr klein ist.

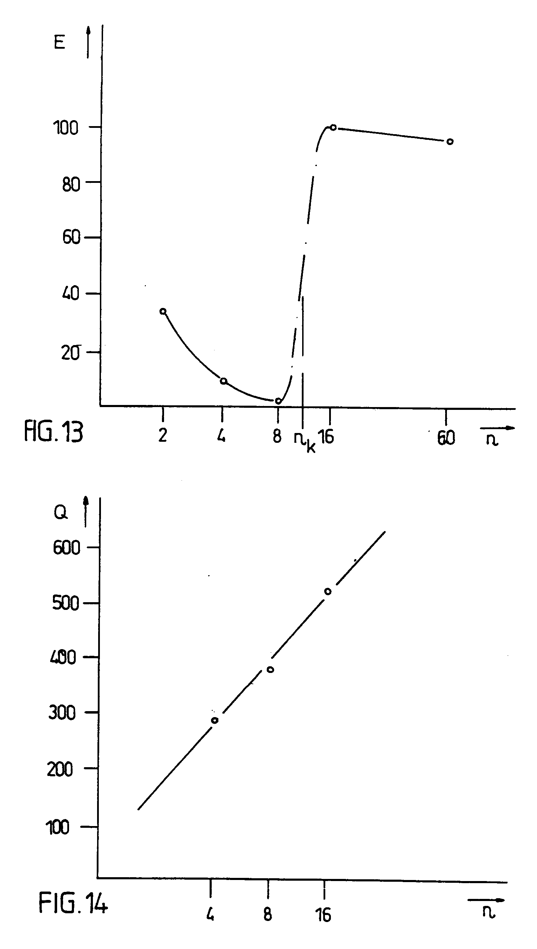

Die vorstehend erläuterten Verhältnisse sind auch aus Fig. 13 erkennbar, wo in willkürlichen Einheiten die elektrische Feldstärke E in einem vorgegebenen Abstand von der Achse auf der Ordinate und die Anzahl n der induktiven bzw. kapazitiven Abschnitte der Hochfrequenz-Spulen auf der Abszisse aufgetragen sind.

Die Messung der elektrischen Feldstärke E wurde etwa auf einem Fünftel des Radius, gemessen vom Mittelpunkt der jeweiligen Hochfrequenz-Spule, vorgenommen.

Man sieht nun aus dem in Fig. 13 dargestellten Verlauf, daß die elektrische Feldstärke E von der zweifach geschlitzten zur vierfach geschlitzten und zur achtfach geschlitzten Spule drastisch abnimmt und dann sprungartig für die sechzehnfach geschlitzte Spule ansteigt, um dort für noch höhere Zahlen n nahezu konstant zu bleiben.

Die in Fig. 13 dargestellten Messungen belegen somit deutlich, daß die Verteilung der Feldlinien des elektrischen Hochfrequenz-Feldes sich zunächst regulär ändert und dann sprungartig in eine andere Verteilungsform übergeht, die sich für noch höhere Werte von n nicht mehr ändert.

Außerdem zeigt Fig. 13, daß die elektrische Feldstärke sich etwa um eine Größenordnung vermindert, wenn von einer zweifach geschlitzten zu einer achtfach geschlitzten Hochfrequenz-Spule übergegangen wird. Berücksichtigt man, wie eingangs erwähnt, daß die dielektrischen Verluste vom Quadrat der elektrischen Feldstärke abhängen, so zeigt Fig. 13 deutlich, daß eine Verminderung der dielektrischen Verluste um ca. zwei Größenordnungen erzielt werden kann.

In Fig. 13 ist mit $n_k$ eine kritische Zahl für die induktiven bzw. kapazitiven Abschnitte bezeichnet. Diese kritische Zahl $n_k$ soll den Übergang von den regulär geformten Verteilungen 22, 46 und 75 zur entarteten, konstanten Verteilung 98 symbolisieren.

Wo diese kritische Zahl $n_k$ genau liegt, hängt im Einzelfall von der Hochfrequenz-Spule ab. Praktische Versuche und theoretische Überlegungen haben indes gezeigt, daß die kritische Zahl $n_k$ in aller Regel bei zehn liegen dürfte, so daß in den allermeisten Fällen ein optimales Ergebnis erzielt wird, wenn die Anzahl n gerade gleich acht (Anordnung der Fig. 5 und 6) gewählt wird. In diesem Falle erhält man einen optimal großen Bereich 73 niedrigster elektrischer Feldstärke und damit einen großen Meßbereich, in dem keine oder nur extrem geringe dielektrische Verluste auftreten.

Fig. 14 zeigt als Vergleich das Ergebnis weiterer Messungen, in denen die Güte Q in Abhängigkeit von der Anzahl n aufgenommen wurde. Fig. 14 zeigt deutlich, daß die Güte linear über der quadratisch aufgetragenen Anzahl n zunimmt, dies liegt daran, daß die Weglänge für den Hochfrequenz-Strom bei einer Erhöhung der Anzahl der kapazitiven Abschnitte abnimmt, wie bereits erläutert wurde.

Kehrt man mit diesen Erkenntnissen nochmals in das optimale Ausführungsbeispiel der Fig. 5 und 6 zurück, so ergibt sich im Hinblick auf eine praktische Dimensionierung des dort gezeigten Probenkopfes 50 folgendes:

Zur Veranschaulichung sei ein charakteristisches Beispiel durchgerechnet, bei dem der Durchmesser D 80 cm betrage. Der hierzu benötigte Magnet zum Erzeugen des Konstant-Magnetfeldes muß also einen Durchmesser von mehr als einem Meter aufweisen.

Bezeichnet man mit R den Radius (R = D/2) und mit a die in Achsrichtung gemessene Breite der Bänder 53 bis 60, so folgt für die Induktivität der Hochfrequenz-Spule 51:

$$L = \mu_0 R \left( \ln \frac{8R}{a} - 2 \right)$$

Damit L so klein wie möglich wird, ist es vorteilhaft, die Breite a möglichst groß zu machen, weil der charakteristische Widerstand $\sqrt{L/C}$ so klein wie möglich sein soll. Außerdem wirken sich breite Bänder (hoher Wert von a) vorteilhaft auf die Homogenität des Hochfrequenz-Magnetfeldes $H_1$ und die Kreisgüte Q aus. Mit R = 0,4 m und a = 0,16 m erhält man mit der oben angegebenen Formel L = 5,03 $10^{-7}$ Henry.

Dem entspricht bei einer Frequenz von 100 MHz ein Kapazitätswert C von 5 pF.

Da wir es im vorliegenden Falle mit einem achtfach geschlitzten Kreis zu tun haben, bei dem die kapazitiven Abschnitte in Reihe geschaltet sind, muß pro Spalt 61 bis 68 ein 8-facher Wert des soeben berechneten Wertes von C, nämlich $C_8$ = 40 pF verwendet werden.

Da jeder der Spalte 61 bis 68 einen Plattenkondensator bildet, errechnet sich die Spaltbreite d nach der bekannten Formel:

$$C_8 = \varepsilon_0 \varepsilon \, F/d = \varepsilon_0 \varepsilon \, ab/d$$

Für die Kapazität des Plattenkondensators folgt, wenn man die Dicke b der Bänder 53 bis 60 mit 1 cm annimmt:

| f/MHz | $C_8$/pF | $d_0$ (Luftspalt)/mm | d(PTFE)/mm |
|---|---|---|---|
| 200 | 10 | 1,415 | 2,83 |
| 100 | 40 | 0,354 | 0,708 |
| 50 | 160 | 0,0885 | 0,177 |

Die Werte in der vierten Spalte sind doppelt so groß wie die Werte in der dritten Spalte, weil PTFE eine Dielektrizitätszahl von 2 hat und damit zur Erzielung desselben Kapazitätswertes die Breite d verdoppelt werden muß.

Die Wellenlänge bei 100 MHz ist 3 m, der Kreisumfang beträgt 2,51 m. Er ist also etwas kleiner als die Wellenlänge. Bei acht Spalten entspricht die Länge eines einzelnen Bandes mit 31,4 Zentimetern etwa 10 % der Wellenlänge.

Verwendet man zwei Hochfrequenz-Spulen 51 in Helmholtz-Anordnung (worauf weiter unten noch eingegangen wird), so ist die gesamte Anordnung 2 mal 16 Zentimeter zuzüglich eines Abstandes von beispielsweise 24 Zentimeter hoch, insgesamt also 56 Zentimeter, was etwas größer ist als ein Sechstel der Wellenlänge.

Aus allen diesen Gründen muß der Resonanzkreis mit einem Außenmantel abgeschirmt werden, um die zahlreichen Antennen nicht wirksam werden zu lassen. Aus diesem Grunde ist der Außenmantel 52 zwingend notwendig, um den magnetischen Rückfluß aufrechtzuerhalten. Der Abstand c des Außenmantels 52 von der Hochfrequenz-Spule 51 beträgt im Beispielsfalle nur 10 cm und liegt damit im Verhältnis zum Durchmesser D um mindestens eine Größenordnung unter entsprechenden relativen Abständen bei Mikrowellen-Anordnungen der Elektronenspinresonanz-Spektroskopie.

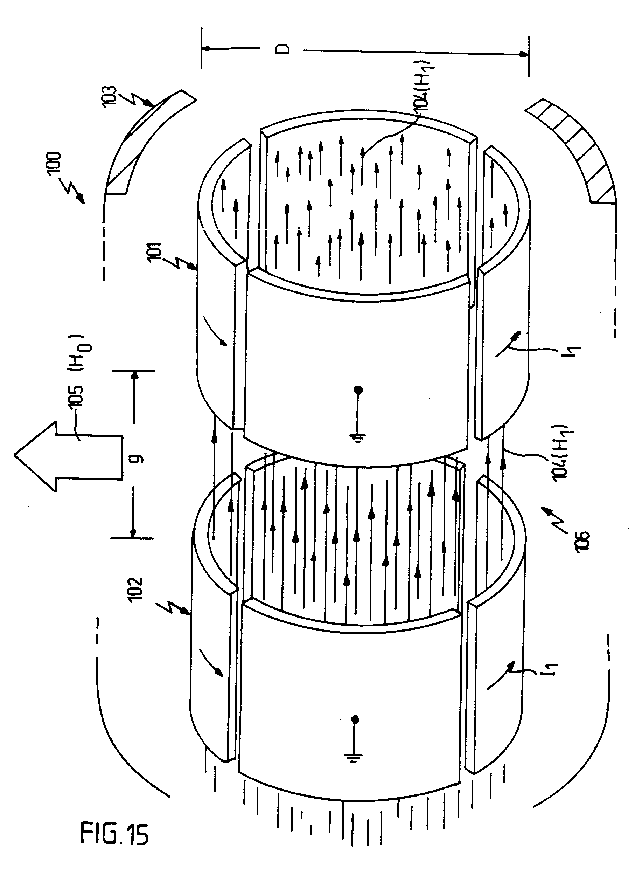

Fig. 15 zeigt ein fünftes Ausführungsbeispiel eines Probenkopfes 100 mit einer ersten Hochfrequenz-Spule 101 und einer zweiten Hochfrequenz-Spule 102. Die Spulen 101, 102 befinden sich wiederum in einem Außenmantel 103. Die Feldlinien 104 des magnetischen Hochfrequenz-Feldes $H_1$ durchsetzen beide Spulen 101, 102 in axialer Richtung, so daß vor allem ein Zwischenraum 106 zwischen den Spulen 101, 102 eine besonders homogene Feldverteilung hat.

Der Zwischenraum 106 ist mit einer Breite g dimensioniert, die kleiner ist als der halbe Durchmesser D der Spulen 101, 102, um die sogenannte Helmholtz-Bedingung zu erfüllen.

Mit 105 ist die Richtung des Konstant-Magnetfeldes $H_0$ bezeichnet, das senkrecht zur Achse der Spulen 101, 102 verläuft.

Mit $I_1$ ist der Hochfrequenz-Strom bezeichnet, der beiden Spulen 101, 102 gleichphasig zugeführt wird.

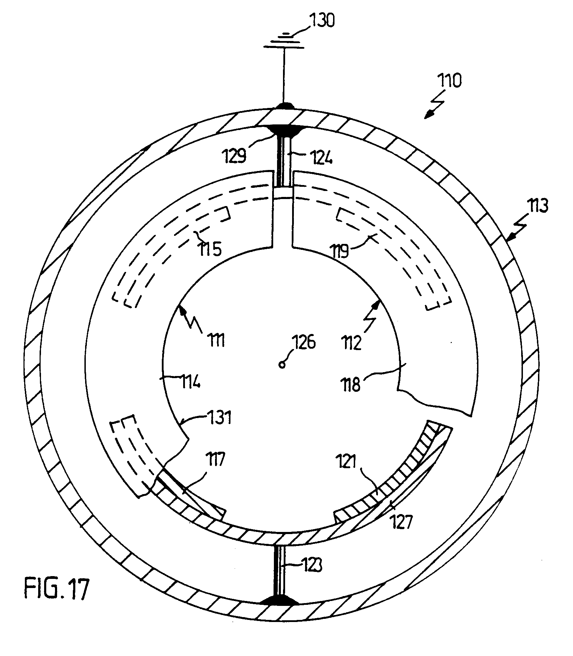

In den Fig. 16 und 17 ist ein sechstes Ausführungsbeispiel eines Probenkopfes 110 dargestellt.

Der Probenkopf 110 weist eine erste Hochfrequenz-Spule 111 und eine zweite Hochfrequenz-Spule 112 auf, die wiederum innerhalb eines zylindrischen Außenmantels 113 angeordnet sind.

Die erste Hochfrequenz-Spule 111 umfaßt vier Bänder 114 bis 117, und die zweite Hochfrequenz-Spule 112 umfaßt ebenfalls vier Bänder 118 bis 121, die zueinander klappsymmetrisch angeordnet sind.

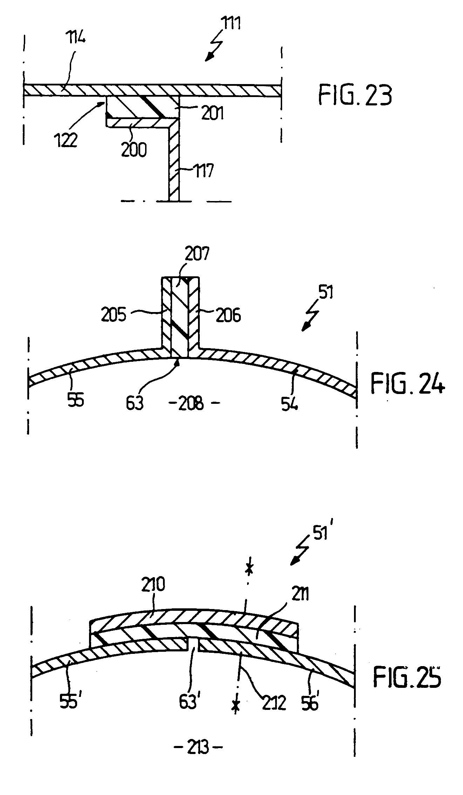

Mit 122 ist angedeutet, daß zwischen den Bändern 114 bis 121 jeweils Spalte vorgesehen sind, wie dies bereits weiter oben erläutert wurde und wie dies weiter unten anhand der Fig. 23 bis 25 noch näher erläutert werden wird.

Die Bänder 114, 116, 118 und 120 sind als Kreisringscheiben-Segmente ausgebildet, während die Bänder 115, 117, 119 und 121 als ebene Bänder oder als geringfügig gewölbte Bänder gestaltet sind. Die Wölbung der letztgenannten Bänder kann entweder in Richtung ihrer Längsachse und/oder in einer Richtung senkrecht dazu vorgenommen sein.

Auf diese Weise ist jede Hochfrequenz-Spule 111, 112 als Sattelspule ausgestaltet, bei der ein guter Zugang zum Innenraum der Spule gewährleistet ist. Außerdem befinden sich die Spulen 111, 112 in Helmholtz-Anordnung.

Über eine erste Leitung 123 und eine zweite Leitung 124 werden die Spulen 111, 112 geerdet.

Mit 125 sind die Feldlinien des elektrischen Hochfrequenz-Feldes $H_1$ angedeutet, die senkrecht zur Achse des Probenkopfes 110 verlaufen. Parallel zur Achse des Probenkopfes 110 verläuft hingegen das Konstant-Magnetfeld $H_0$, wie mit einer Feldlinie 126 angedeutet.

Zur Erdung der Hochfrequenz-Spulen 111, 112 ist jeweils eine Erdungsschiene 127 vorgesehen, die einerseits die Bänder 117 und 121 und von denen eine zweite die Bänder 115 und 119 elektrisch und mechanisch verbindet.

Mit 135 und 136 sind in Fig. 16 die beiden Ebenen bezeichnet, in denen die elektrische Feldstärke gleich Null ist, dies entspricht dem in Fig. 10 veranschaulichten Fall mit den dort eingezeichneten beiden gestrichelten Ebenen, in denen die elektrische Feldstärke gleich Null ist.

Fig. 17 zeigt hierzu in weiteren Einzelheiten, daß die erste Leitung 123 sowie die gegenüberliegende zweite Leitung 124 bei 129 mit dem Abschirmgehäuse 113 verlötet ist, das an Masse liegt, wie bei 130 angedeutet.

Es wurde bereits erwähnt, daß Sattelspulen einen guten Zugang zum Innenraum der Spule, insbesondere bei Helmholtz-Anordnungen, gestatten.

Hierzu zeigen die Fig. 16 und 17 bei 131 die durch die Kreisringsegment-Form der Bänder 114, 116, 118, 120 gebildeten Öffnungen, die mit einer oder zwei Öffnungen 132 auf einer Stirnseite oder beiden Stirnseiten des Außenmantels 113 fluchten.

Die Fig. 16 und 17 lassen ferner deutlich erkennen, daß die Hochfrequenz-Spulen 111, 112 eine selbsttragende Anordnung bilden, die überdies mittels der elektrischen Zuleitungen 123, 124 mechanisch stabil im Außenmantel 113 gehalten ist, ohne daß zusätzliche Stützelemente erforderlich sind.

Es darf an dieser Stelle angemerkt werden, daß die Beschränkung auf eine vierfach gespaltete Hochfrequenz-Spule in den beiden zuletzt geschilderten Ausführungsbeispielen der Fig. 15 bis 17 lediglich aus Gründen der Einfachheit gewählt wurde, während damit keinesfalls ausgedrückt ist, daß von der als optimal erkannten achtfach gespalteten Anordnung abgewichen werden soll. Dies gilt auch für die im folgenden beschriebenen Ausführungsbeispiele, bei denen ebenfalls aus Gründen der Übersichtlichkeit teilweise Anordnungen mit kleinerer Anzahl n gezeigt sind.

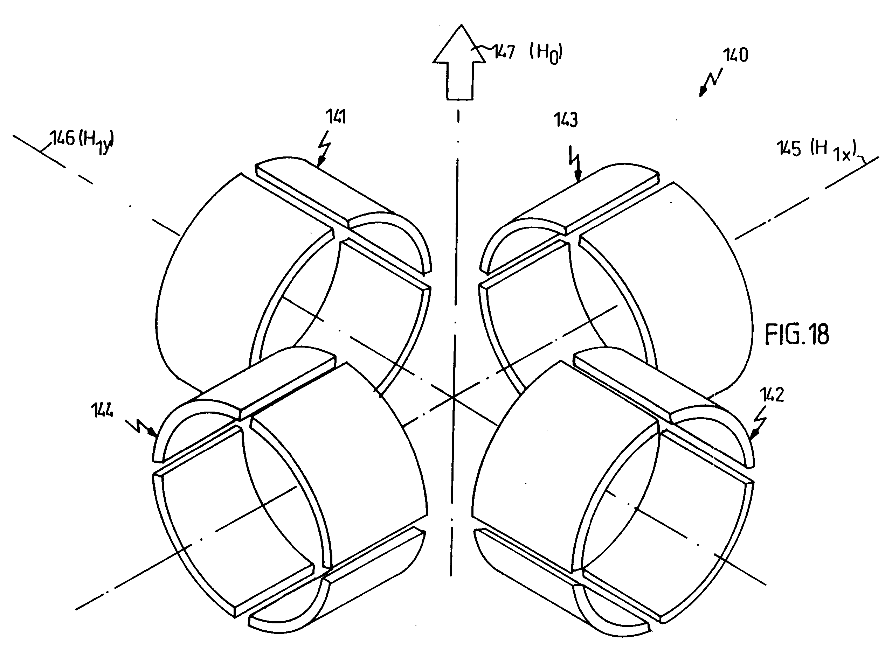

Fig. 18 zeigt nun ein siebtes Ausführungsbeispiel eines erfindungsgemaßen Probenkopfes 140 mit einem ersten Paar von Hochfrequenz-Spulen 141, 142 und einem zweiten Paar von Hochfrequenz-Spulen 143 und 144.

Achsen 145, 146 für das magnetische Hochfrequenz-Feld $H_{1x}$ bzw. $H_{1y}$ verlaufen unter einem Winkel von 90° zueinander und wiederum unter einem Winkel von 90° zu einer dritten kartesischen Achse 147, die in Richtung des Konstant-Magnetfeldes $H_0$ liegt.

Die Anordnung der Fig. 18 gestattet es, Meßproben auf weitere unterschiedliche Arten zu untersuchen.

Bei einer dieser Meßarten werden den beiden Paaren Anregungssignale gleicher Frequenz aber unterschiedlicher Phasenlage zugeführt, so daß im Meßraum (im Koordinatenursprung der Darstellung der Fig. 18) ein zirkularpolarisiertes Hochfrequenz-Magnetfeld entsteht. Ein solches zirkularpolarisiertes Feld kann in vorteilhafter Weise für Messungen mit Quadratur-Detektion verwendet werden.

Bei einer anderen Meßart wird über eines der Paare von Hochfrequenz-Spulen angeregt, und das andere Paar von Hochfrequenz-Spulen dient als Empfänger. Bei einer derartigen Induktionsanordnung nach dem sogenannten Bloch'schen Meßverfahren erzielt man eine gute Entkopplung der beiden Kreise (des Senders und des Empfängers) voneinander, so daß bei hohen Anregungs-Feldstärken lediglich Meßsignale, nicht jedoch eingekoppelte Streusignale aus dem Sender in den Empfänger gelangen.

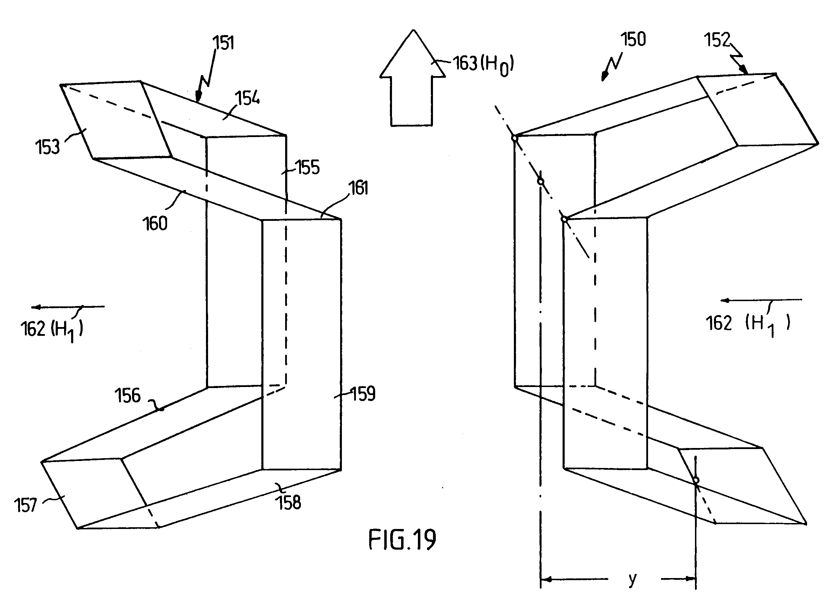

Fig. 19 zeigt ein achtes Ausführungsbeispiel eines erfindungsgemäßen Probenkopfes 150, bei dem ebenfalls zwei Hochfrequenz-Spulen 151 und 152 in Helmholtz-Anordnung verwendet werden.

Das Besondere des Probenkopfes 150 liegt darin, daß die Hochfrequenz-Spulen 151, 152 aus ebenen Bändern 153 bis 160 gebildet werden, wobei die in Fig. 19 erkennbaren Knickstellen zwischen den Bändern zugleich die nicht näher dargestellten Spalte 161 bilden.

In einer Seitenansicht hätte die Anordnung der Fig. 19 die Gestalt eines regelmäßigen Achtecks. Die Anordnung ist jedoch so gewählt, daß wiederum zwei Sattelspulen entstehen, indem die jeweils beiden vorderen Bänder 155 und 159 (in Richtung auf den Meßraum gesehen) um einen Betrag y gegenüber den nach hinten weisenden Bändern 153 und 157 versetzt sind und die übrigen Bänder 154, 156, 158 und 160 die Verbindung zu den zuvor genannten Bändern herstellen.

Mit 162 sind in Fig. 19 die Feldlinien des magnetischen Hochfrequenz-Feldes $H_1$ und mit 163 eine Feldlinie des Konstant-Magnetfeldes $H_0$ bezeichnet.

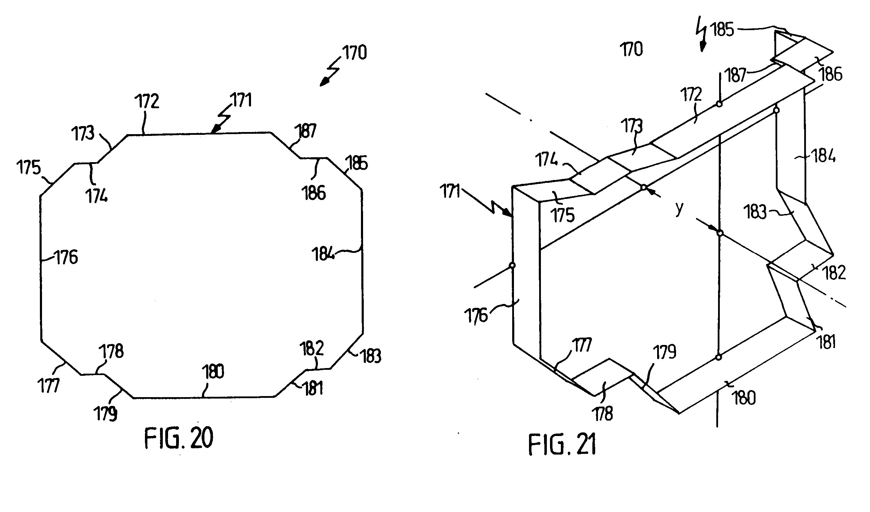

Ein neuntes Ausführungsbeispiel 170 eines Probenkopfes ist in den Fig. 20 und 21 dargestellt.

Bei diesem Ausführungsbeispiel umfaßt der Probenkopf 170 eine Hochfrequenz-Spule 171 mit sechzehn Bändern 172 bis 187, die ähnlich der Anordnung der Fig. 19 nach Art einer Sattelspule ausgebildet sind, wie die perspektivische Darstellung der Fig. 21 zeigt. Die Sattelform ergibt sich auch hier aus dem axialen Versatz y zwischen den beiden Bändern 172 und 180 zu den beiden Bändern 176 und 184.

Eine Besonderheit der Hochfrequenz-Spule 171 liegt darin, daß jeweils vier lange Bänder 172, 176, 180 und 184 verwendet werden, die über kurze Bandstücke an ihren freien Enden miteinander verbunden sind. Bei diesen kurzen Stücken bilden die Bänder 174, 178, 182 und 186 ebene Abschnitte, die symmetrisch zueinander und symmetrisch zur Mittelachse angeordnet sind.

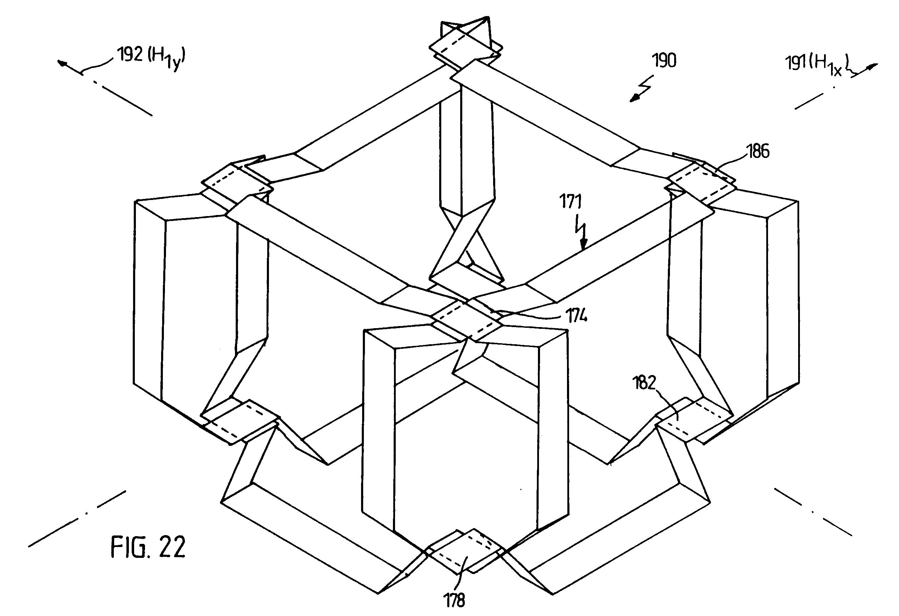

Dies gestattet es, eine Doppel-Helmholtz-Anordnung ähnlich derjenigen der Fig. 18 aufzubauen, so wie dies in Fig. 22 dargestellt ist.

Das dort perspektivisch erkennbare zehnte Ausführungsbeispiel 190 eines Probenkopfes ist aus vier Hochfrequenz-Spulen 171 gemäß Fig. 20 und 21 zusammengesetzt.

Die eben und symmetrisch angeordneten Abschnitte 174, 178, 182 und 186 gestatten es dabei, die vier Spulen 171 so ineinander zu verschachteln, daß die genannten ebenen Abschnitte aufeinanderliegen und mechanisch aber isoliert miteinander verbunden werden können. Selbstverständlich ist damit lediglich ein mechanischer Verbund, nicht jedoch eine elektrische Wechselwirkung zwischen den jeweiligen Spulen 171 vorgesehen.

Auf diese Weise ergibt sich wiederum eine Doppel-Helmholtz-Anordnung mit zwei Achsen 191 und 192 für die Feldlinien des magnetischen Hochfrequenz-Feldes $H_{1x}$ und $H_{1y}$.

Fig. 23 zeigt in einem Detail die praktische Ausbildung eines Spaltes, dargestellt am Spalt 122 der Hochfrequenz-Spule 111 des Probenkopfes 110 der Fig. 16 und 17.

Man erkennt aus der vergrößerten Detaildarstellung der Fig. 23, daß das Band 117 am oberen Ende in einen Winkelabschnitt 200 ausläuft, der parallel zum Band 114 verläuft. Der dazwischen ausgebildete Spalt 122 ist mit einem Dielektrikum 201 ausgefüllt. Das Dielektrikum 201 kann PTFE sein, wobei zu berücksichtigen ist, daß dessen Dielektrizitätszahl $\varepsilon$ ungefähr gleich 2 ist.

Auf diese Weise wird nicht nur der kapazitive Abschnitt im Bereich des Spaltes 122 definiert, es ist auch ein mechanischer Verbund zwischen dem Winkel 200 und dem Band 114 möglich.

Entsprechendes gilt für die Detaildarstellung der Fig. 24, bei der als Beispiel die Bänder 54 und 55 der Hochfrequenz-Spule 51 des Probenkopfes 50 der Fig. 5 und 6 dargestellt sind.

Die Bänder 54, 55, die zwischen sich den Spalt 63 einschließen, laufen an ihren freien Enden in Umkantungen 205, 206 aus, die zwischen sich ein Dielektrikum 207 einschließen und radial nach außen, d.h. von einem Innenraum 208 der Hochfrequenz-Spule 51 weg verlaufen.

Auf diese Weise werden die elektrischen Feldlinien weiter nach außen gezogen und belasten den Innenraum 208 weniger.

Schließlich zeigt Fig. 25 noch eine Detaildarstellung, bei der eine Variante der Fig. 24 dargestellt ist. Die Bänder 55', 56' sind in diesem Falle mit einem überlappenden metallischen Streifen 210 überdeckt. Zwischen dem Streifen 210 und den Bändern 55', 56' befindet sich wiederum ein Dielektrikum 211. Der Spalt 63' kann dabei frei bleiben oder ebenfalls mit Dielektrikum ausgefüllt werden.

Das Dielektrikum 211 kann in diesem Falle, ebenso wie bei den in Fig. 23 und 24 dargestellten Fällen auch durch einen Kleber gebildet werden, der zugleich die elektrische Eigenschaft des Dielektrikums und auch die mechanische Verbindung gewärleistet.

Alternativ oder zusätzlich ist auch eine Verschraubung möglich, wie in Fig. 25 mit 212 angedeutet. Es versteht sich, daß in diesem Falle eine elektrisch nicht-leitende Schraube, z.B. eine Schraube aus PTFE, eingesetzt wird.

Auch in diesem Falle wird ein Innenraum 213 der Spule 51' weitgehend von elektrischen Feldlinien entlastet.

## Patentansprüche

1.  Probenkopf für die Kernresonanz-Ganzkörper-Tomographie, oder die ortsabhängige in-vivo Kernresonanz-Spektroskopie mit einer Hochfrequenz-Spule (11; 31; 51; 81; 101, 102; 111, 112; 141 bis 144; 151, 152; 171), die jeweils eine Anzahl (n) von in Richtung des Hochfrequenz-Stromes ($I_1$) abwechselnd hintereinander angeordneten induktiven Abschnitten in Gestalt von metallischen Bändern (13, 14; 33 bis 36; 53 bis 60; 83 bis 88; 114 bis 121; 153 bis 160; 172 bis 187) sowie kapazitiven Abschnitten umfaßt, derart, daß die Feldlinien (20; 44; 72; 104; 125; 145, 146; 162; 191, 192) des von der Hochfrequenz-Spule (11; 31; 51; 81; 101, 102; 111, 112; 141 bis 144; 151, 152; 171) erzeugten Hochfrequenz-Magnetfeldes ($H_1$) parallel zu einer von der Hochfrequenz-Spule (11; 31; 51; 81; 101, 102; 111, 112; 141 bis 144, 151, 152; 171) umschlossenen Achse (21; 45; 74; 125) verlaufen, dadurch gekennzeichnet, daß die Hochfrequenz-Spule (31; 51; 81; 101, 102; 111, 112; 141 bis 144; 151, 152; 171) zusammen mit einem Außenmantel (32; 52; 82; 103; 113) eine Einheit bildet, und daß die Anzahl (n) der induktiven und der kapazitiven Abschnitte so bemessen ist, daß sie gerade unterhalb desjenigen Grenzwertes ($n_k$) liegt, bei dessen Überschreitung die Verteilung (22; 46; 75) der Feldlinien (19; 43; 71; 97) des von der Hochfrequenz-Spule (11; 31; 51; 81; 101, 102; 111, 112; 141 bis 144; 151, 152; 171) erzeugten elektrischen Hochfrequenz-Feldes ($E_1$) von einer ersten Verteilung (22; 46; 75), bei der sich von jedem induktiven Abschnitt (55) zur Achse (74) eine Ebene (76) erstreckt, in der die Stärke des elektrischen Hochfrequenz-Feldes ($E_1$) gleich Null ist, in eine zweite Verteilung (98) umkippt, bei der die Stärke des elektrischen Hochfrequenz-Feldes ($E_1$) unabhängig von der Anzahl (n) der induktiven Abschnitte im wesentlichen rotationssymmetrisch um die Achse (99) und linear von der Achse (99) zur Hochfrequenz-Spule (81) hin ansteigend verläuft.

2.  Probenkopf nach Anspruch 1, dadurch gekennzeichnet, daß die kapazitiven Abschnitte als Spalte (37 bis 40; 61 bis 68; 89 bis 94; 122; 161) ausgebildet sind, die parallel zu den Feldlinien (44; 72; 104; 125; 145, 146; 162; 191, 192) des Hochfrequenz-Magnetfeldes ($H_1$) verlaufen.

3.  Probenkopf nach Anspruch 2, dadurch gekennzeichnet, daß die Spalte (63; 122) mit einem Dielektrikum (201; 207; 211) ausgefüllt sind.

4.  Probenkopf nach Anspruch 2 oder 3, dadurch gekennzeichnet, daß die metallischen Bänder (54, 55) an ihren an die Spalte (63) angrenzenden Rändern vom Innenraum (208) der Hochfrequenz-Spule (51) weg gebogen sind, derart, daß die kapazitiven Abschnitte außerhalb des Innenraumes (208) liegen.

5.  Probenkopf nach einem der Ansprüche 1 bis 4, dadurch gekennzeichnet, daß die Bänder (153 bis 160; 172 bis 187) eben sind.

6.  Probenkopf nach einem der Ansprüche 1 bis 4, dadurch gekennzeichnet, daß die Bänder (33 bis 36; 53 bis 60; 83 bis 88; 114 bis 121) gewölbt, vorzugsweise in der Richtung des Hochfrequenz-Stromes ($I_1$) gebogen sind.

7. Probenkopf nach einem der Ansprüche 1 bis 6, dadurch gekennzeichnet, daß die metallischen Bänder (53 bis 60; 114 bis 121; 153 bis 160; 172 bis 187) an den kapazitiven Abschnitten starr miteinander verbunden sind.

8. Probenkopf nach Anspruch 7, dadurch gekennzeichnet, daß die metallischen Bänder (55′, 56′) mittels eines Klebstoffes miteinander verklebt sind.

9. Probenkopf nach Anspruch 8, dadurch gekennzeichnet, daß der Klebstoff ein Dielektrikum (211) bildet.

10. Probenkopf nach Anspruch 7, dadurch gekennzeichnet, daß die metallischen Bänder (55′, 56′) miteinander isoliert verschraubt sind.

11. Probenkopf nach einem der Ansprüche 2 bis 10, dadurch gekennzeichnet, daß die Breite d der Spalte (61 bis 68) in Richtung des Hochfrequenz-Stromes ($I_1$) zwischen 0,1 % und 2 %, vorzugsweise bei 0,5 % des Umfanges der Hochfrequenz-Spule (51) liegt.

12. Probenkopf nach einem der Ansprüche 1 bis 11, dadurch gekennzeichnet, daß eine erste Abmessung (I) der metallischen Bänder (53 bis 60) in Richtung des Hochfrequenz-Stromes ($I_1$) nicht mehr als das Vierfache einer zweiten, dazu senkrechten Abmessung (a) beträgt.

13. Probenkopf nach Anspruch 12, dadurch gekennzeichnet, daß eine zur Richtung des Hochfrequenz-Stromes ($I_1$) senkrechte Abmessung (a) der metallischen Bänder (53 bis 60) zwischen 10 % und 50 %, vorzugsweise bei 20 % des Durchmessers (D) der Hochfrequenz-Spule (51) liegt.

14. Probenkopf nach Anspruch 13, dadurch gekennzeichnet, daß der Außenmantel (52) eine im wesentlichen kreiszylindrische Form aufweist und die Hochfrequenz-Spule (51) in einem Abstand (c) umgibt, der zwischen 5 % und 20 %, vorzugsweise bei 10 % des Durchmessers (D) der Hochfrequenz-Spule (51) liegt.

15. Probenkopf nach einem der Ansprüche 1 bis 14, dadurch gekennzeichnet, daß er zwei Hochfrequenz-Spulen (101, 102; 111, 112; 141, 142; 143, 144; 151, 152; 171) in Helmholtz-Anordnung umfaßt.

16. Probenkopf nach einem der Ansprüche 1 bis 15, dadurch gekennzeichnet, daß er vier Hochfrequenz-Spulen (141 bis 144; 171) umfaßt, von denen jeweils zwei (141/142, 143/144) ein Paar in Helmholtz-Anordnung bilden und die Achsen (145, 146) der Paare (141/142, 143/144) aufeinander senkrecht stehen.

17. Probenkopf nach Anspruch 15 oder 16, dadurch gekennzeichnet, daß die Hochfrequenz-Spulen (111, 112; 151, 152; 171) als Sattelspulen ausgebildet sind.

18. Probenkopf nach Anspruch 16 und 17, dadurch gekennzeichnet, daß die Sattelspulen derart ausgebildet und zueinander angeordnet sind, daß jede Sattelspule eines Paares mit mindestens einem Punkt an den beiden Sattelspulen des jeweils anderen Paares anliegt und dort befestigt ist.

19. Probenkopf nach Anspruch 17, dadurch gekennzeichnet, daß die Sattelspulen zwei kreisringsegmentförmige Bänder (114, 116, 118, 120) sowie zwei langgestreckte, vorzugsweise in Längs- und/oder Querrichtung gewölbte Bänder (115, 117, 119, 121) umfassen, die mit ihren freien Enden unter einem Winkel von 90° zu den kreisringsegmentförmigen Bändern (114, 116, 118, 120) hin verlaufen.

20. Probenkopf nach einem der Ansprüche 1 bis 19, dadurch gekennzeichnet, daß mindestens eine als Erdung dienende Leitung (123, 124) für den Hochfrequenz-Strom ($I_1$) als Halterung für die metallischen Bänder (114 bis 121) an dem Außenmantel (113) ausgebildet ist.

21. Verwendung des Probenkopfes nach einem der Ansprüche 1 bis 20 als Oberflächenspule.


**Claims**

1. Sample head for nuclear magnetic resonance whole-body tomography or localized in-vivo nuclear magnetic resonance spectroscopy, comprising an RF coil (11; 31; 51; 81; 101, 102; 111, 112; 141 to 144; 151, 152; 171) having a plurality (n) of inductive sections in the form of metallic strips (13, 14; 33 to 36; 53 to 60; 83 to 88; 114 to 121; 153 to 160; 172 to 187) and capacitive sections, respectively, arranged alternately one behind the other in the direction of the RF current ($I_1$), so that the field lines (20; 44; 72; 104; 125; 145, 146; 162; 191, 192) of the magnetic RF field (H1) generated by the RF coil (11; 31; 51; 81; 101, 102; 111, 112; 141 to 144; 151, 152; 171) extend in parallel to an axis (21; 45; 74; 125) surrounded by the RF coil (11; 31; 51; 81; 101, 102; 111, 112; 141 to 144; 151, 152; 171), characterized in that the RF coil (31; 51; 81; 101, 102; 111, 112; 141 to 144; 151, 152; 171) together with an outer jacket (32; 52; 82; 103; 113) forms a single unit and that the number (n) of inductive and capacitive sections is such as to be just below that limit value ($n_k$) above which the distribution (22; 46; 75) of the field lines (19; 43; 71; 97) of the electric RF field ($E_1$) produced by the RF coil 102; 111, 112; 141 to 144; 151, 152; 171) flips from a first distribution (22; 46; 75), where there is a plane (76) extending between each inductive section (strip 55) and the axis (74) in which the strength of the electric RF field ($E_1$) is equal to zero, to a second distribution (98) where the strength of the electric RF field ($E_1$) rises in a substantially rotationally symmetrical pattern around the axis (99), and linearly from the axis (99) toward the RF coil (81) independently from the number (n) of the inductive sections.

2. The sample head of claim 1, characterized in that the capacitive sections are designed as gaps (37 to 40; 61 to 68; 89 to 94; 122; 161) extending in parallel to the field lines (44; 72; 104; 125; 145, 146; 162; 191, 192) of the magnetic RF field ($H_1$)

3. The sample head of claim 2, characterized in that the gaps (63; 122) are filled with a dielectric material (201; 207; 211).

4. The sample head of claim 2 or 3, characterized in that the edges of the metallic strips (54, 55) adjoining the gaps (63) are bent off in a direction away from the interior (208) of the RF coil (51) so that the capacitive sections come to lie outside of the interior (208) of the coil.

5. The sample head of any of claims 1 to 4, characterized in that the strips (53 to 160; 172 to 187) are flat.

6. The sample head of any of claims 1 to 4, characterized in that the strips (33 to 36; 53 to 60; 83 to 88; 114 to 121) are curved, preferably bent in the direction of the RF current ($I_1$).

7. The sample head of any of claims 1 to 6, characterized in that the metallic strips (53 to 60; 114 to 121; 153 to 160; 172 to 187) are rigidly interconnected at the capacitive sections.

8. The sample head of claim 7, characterized in that the metallic strips (55', 56') are bonded together by means of an adhesive.

9. The sample head of claim 8, characterized in that the adhesive acts as a dielectric material.

10. The sample head of claim 7, characterized in that the metallic strips (55', 56') are bolted together in insulated relationship.

11. The sample head of any of claims 2 to 10, characterized in that the width d of the gaps (61 to 68) in the direction of the RF current ($I_1$) is between 0.1 % and 2 %, preferably in the range of 0.5 % of the circumference of the RF coil (51).

12. The sample head of any of claims 1 to 11, characterized in that a first dimension (I) of the metallic strips (53 to 60), in the direction of the said RF current ($I_1$), is not greater than four times a second dimension (a) perpendicular thereto.

13. The sample head of claim 12, characterized in that a dimension (1) of the metallic strips (53 to 60) perpendicular to the direction of the RF current ($I_1$) is equal to between 10 % and 50 %, preferably 20 %, of the diameter (D) of the RF coil (51).

14. The sample head of claim 13, characterized in that the outer jacket (52) has a substantially circular-cylindrical shape and surrounds the RF coil (51) at a distance (c) equal to between 5 % and 20 %, preferably 10 %, of the diameter (D) of the RF coil (51).

15. The sample head of any of claims 1 to 14, characterized in that it comprises two RF coils (101, 102; 111, 112; 141, 142; 143, 144; 151, 152; 171) in a Helmholtz arrangement.

16. The sample head of any of claims 1 to 15, characterized in that it comprises four RF coils (141 to 144; 171), with every two of them (141/142), 143/144) forming a pair in Helmholtz arrangement, the axes (145, 146) of the pairs (141/142, 143/144) extending perpendicular one to each other.

17. The sample head of claim 15 or 16, characterized in that the RF coils (111, 112; 151, 152; 171) are designed as saddle coils.

18. The sample head of claims 16 and 17, characterized in that the saddle coils are designed and oriented towards each other such that each saddle coil of a pair is in contact with, and fixed to, the two other saddle coils of the other pair by at least one point.

19. The sample head of claim 17, characterized in that the saddle coils comprise two strips (114, 116, 118, 120) in the form of annular segments, as well as two elongated strips (115, 117, 119, 121) being preferably curved in the longitudinal and/or transverse direction and whose free ends extend to an angle of 90° relative to those strips (114, 116, 118, 120) having the form of annular segments.

20. The sample head of any of claims 1 to 19, characterized in that at least one line (123, 124) for the RF current ($I_1$), serving as grounding line, is designed for fastening the metallic strips (114 to 121) on the outer jacket (113).

21. Use of the sample head of any of claims 1 to 20, as a surface coil.

## Revendications

1. Sonde pour la tomographie à résonance magnétique nucléaire de tout le corps ou pour la spectroscopie à résonance magnétique nucléaire in vivo localisée, comportant une bobine haute fréquence (11 ; 31 ; 51 ; 81 ; 101, 102 ; 111, 112 ; 141 à 144 ; 151, 152 ; 171) qui comprend à la fois un certain nombre (n) de sections inductives disposées alternativement l'une à la suite de l'autre dans la direction du courant haute fréquence ($I_1$) et se présentant sous la forme de bandes métalliques (13, 14 ; 33 à 36 ; 53 à 60 ; 83 à 88 ; 114 à 121 ; 153 à 160 ; 172 à 187), ainsi que de sections capacitives, de telle sorte que les lignes de champ (20 ; 44 ; 72 ; 104 ; 126 ; 145, 146 ; 162 ; 191 ; 192) du champ magnétique haute fréquence ($H_1$) produit par la bobine haute fréquence (11 ; 31 ; 51 ; 81 ; 101, 102 ; 111, 112 ; 141 à 144 ; 151, 152 ; 171) soient disposées parallèlement à un axe (21 ; 45 ; 74 ; 125) entouré par la bobine haute fréquence (11 ; 31 ; 51 ; 81 ; 101, 102 ; 111, 112 ; 141 à 144 ; 151, 152 ; 171), caractérisée en ce que la bobine haute fréquence (31 ; 51 ; 81 ; 101, 102 ; 111, 112 ; 141 à 144 ; 151, 152 ; 171) forme, avec une enveloppe extérieure (32 ; 52 ; 82 ; 103 ; 113), une unité, et en ce que le nombre (n) de sections inductives et capacitives est limité de telle sorte qu'il se situe juste en deçà de la valeur limite ($n_k$) au-dessus de laquelle la distribution (22 ; 46 ; 75) des lignes de champ (19 ; 43 ; 71 ; 97) du champ électrique haute fréquence ($E_1$) engendré par la bobine haute fréquence (11 ; 31 ; 51 ; 81 ; 101, 102 ; 111, 112 ; 141 à 144 ; 151, 152 ; 171) bascule d'une première distribution (22 ; 46 ; 75), dans laquelle l'intensité du champ électrique haute fréquence (E1) dans le plan (76) qui s'étend de chaque section inductive (55) à l'axe (74) est égale à zéro, à une seconde distribution (98) dans laquelle l'intensité du champ électrique haute fréquence ($E_1$), quel que soit le nombre (n) de sections inductives, présente pratiquement une symétrie de rotation autour de l'axe (99) et croît de façon linéaire en allant de l'axe (99) vers la bobine haute fréquence (81).

2. Sonde selon la revendication 1, caractérisée en ce que les sections capacitives sont constituées sous forme d'entrefers (37 à 40 ; 61 à 68 ; 89 à 94 ; 122 ; 161) disposés parallèlement aux lignes de champ (44 ; 72 ; 104 ; 125 ; 145, 146 ; 162 ; 191 ; 192) du champ magnétique haute fréquence ($H_1$).

3. Sonde selon la revendication 2, caractérisée en ce que les entrefers (63 ; 122) sont remplis par un diélectrique (201 ; 207 ; 211).

4. Sonde selon les revendications 2 ou 3, caractérisée en ce que les bords des bandes métalliques (54, 55) contigus à l'entrefer (63) sont recourbés en s'éloignant de l'espace intérieur (208) de la bobine haute fréquence (51), de façon à ce que les sections capacitives se trouvent en dehors de l'espace intérieur (208).

5. Sonde selon l'une quelconque des revendications 1 à 4, caractérisée en ce que les bandes (153 à 160 ; 172 à 187) sont planes.

6. Sonde selon l'une quelconque des revendications 1 à 4, caractérisée en ce que les bandes (33 à 36 ; 53 à 60 ; 83 à 88 ; 114 à 121) sont recourbées, de préférence dans la direction du courant haute fréquence ($I_1$).

7. Sonde selon l'une quelconque des revendications 1 à 6, caractérisée en ce que les bandes métalliques (53 à 60 ; 114 à 121 ; 153 à 160 ; 172 à 187) sont fixées entre elles de façon rigide aux sections capacitives.

8. Sonde selon la revendication 7, caractérisée en ce que les bandes métalliques (55', 56') sont collées entre elles au moyen d'un adhésif.

9. Sonde selon la revendication 8, caractérisée en ce que l'adhésif constitue un diélectrique (211).

10. Sonde selon la revendication 7, caractérisée en ce que les bandes métalliques (55', 56') sont fixées ensemble au moyen de vis isolantes.

11. Sonde selon l'une quelconque des revendications 2 à 10, caractérisée en ce que la largeur (d) de l'entrefer (61 à 68) dans la direction du courant haute fréquence ($I_1$) est comprise entre 0,1 % et 2 %, et est de préférence égale à 0,5 % du périmètre de la bobine haute fréquence (51).

12. Sonde selon l'une quelconque des revendications 1 à 11, caractérisée en ce qu'une première dimension (1) des bandes métalliques (53 à 60) dans la direction du courant haute fréquence ($I_1$) ne dépasse pas quatre fois une seconde dimension (a) perpendiculaire à la première.

13. Sonde selon la revendication 12, caractérisée en ce qu'une dimension (a) des bandes métalliques (53 à 60) dans une direction perpendiculaire à la direction du courant haute fréquence ($I_1$) est comprise entre 10 % et 50 % et est de préférence égale à 20 % du diamètre (D) de la bobine haute fréquence (51).

14. Sonde selon la revendication 13, caractérisée en ce que l'enveloppe extérieure (52) a essentiellement la forme d'un cylindre à base circulaire et entoure la bobine haute fréquence (51) à une distance (c) qui est comprise entre 5 % et 20 % et qui est de préférence égale à 10 % du diamètre (D) de la bobine haute fréquence (51).

15. Sonde selon l'une quelconque des revendications 1 à 14, caractérisée en ce qu'elle comprend deux bobines haute fréquence (101, 102 ; 111, 112 ; 141, 142 ; 143, 144 ; 151, 152 ; 171) en montage d'Helmholtz.

16. Sonde selon l'une quelconque des revendications 1 à 15, caractérisée en ce que la sonde comprend quatre bobines haute fréquence (141 à 144 ; 171), couplées deux par deux (141/142, 143/144) en montage d'Helmholtz, les axes (145, 146) des deux paires (141/142, 143/144) étant perpendiculaires entre eux.

17. Sonde selon les revendications 15 ou 16, caractérisée en ce que les bobines haute fréquence (111, 112 ; 151, 152 ; 171) sont constituées en tant que bobines en sellette.

18. Sonde selon les revendications 16 ou 17, caractérisée en ce que les bobines en sellette sont constituées et disposées les unes par rapport aux autres, de telle sorte que chaque bobine en sellette d'une paire ait au moins un point en contact avec les deux bobines en sellette de l'autre paire et y soit fixée.

19. Sonde selon la revendication 17, caractérisée en ce que les bobines en sellette comportent deux bandes (114, 116, 118, 120) en forme de segments d'anneau circulaire, ainsi que deux bandes (115, 117, 119, 121) allongées, de préférence cintrées dans le sens longitudinal et/ou transversal, leurs extrémités libres étant coudées à 90° par rapport aux bandes (114, 116, 118, 120) en forme de segments d'anneau circulaire.

**20.** Sonde selon l'une quelconque des revendications 1 à 19, caractérisée en ce qu'au moins un conducteur (123, 124) servant de mise à la terre pour le courant haute fréquence ($I_1$) sert de moyen de fixation des bandes métalliques (114 à 121) sur l'enveloppe extérieure (113).

**21.** Utilisation de la sonde selon l'une quelconque des revendications 1 à 20 en tant que bobine de surface.

EP 0 432 241 B1

FIG.1

FIG.2

19

FIG. 3

FIG. 4

FIG.5

FIG.6

FIG.7

FIG.8

FIG. 9

FIG. 10

FIG. 11

FIG. 12

FIG.13

FIG.14

FIG.15

FIG. 16

FIG.17

FIG.18

EP 0 432 241 B1

FIG.19

FIG. 20

FIG. 21

EP 0 432 241 B1

FIG. 22

EP 0 432 241 B1

FIG. 23

FIG. 24

FIG. 25